(19) Europäisches Patentamt

European Patent Office

Office européen des brevets

(11) **EP 1 717 593 A2**

(12) **EUROPÄISCHE PATENTANMELDUNG**

(43) Veröffentlichungstag:
**02.11.2006 Patentblatt 2006/44**

(51) Int Cl.:
***G01R 33/035*** (2006.01)

(21) Anmeldenummer: **06016995.0**

(22) Anmeldetag: **01.08.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **02.08.2002 DE 10235633**

(62) Dokumentnummer(n) der früheren Anmeldung(en)
nach Art. 76 EPÜ:
**03017464.3 / 1 387 178**

(71) Anmelder:
• **QEST Quantenelektronische Systeme GmbH
72768 Reutlingen (DE)**
• **IPHT Jena
07745 Jena (DE)**

(72) Erfinder:
• **Oppenländer, Jörg, Dr.
72138 Kirchentellinsfurt (DE)**
• **Zakosarenko, Viatcheslav, Dr.
07747 Jena (DE)**
• **Schultze, Volkmar, Dr.
07751 Sulza (DE)**
• **Ijsselsteijn, Rob, Dr.
07743 Jena (DE)**

(74) Vertreter: **Eisele, Otten, Roth & Dobler
Karlstrasse 8
88212 Ravensburg (DE)**

Bemerkungen:
Diese Anmeldung ist am 16 - 08 - 2006 als
Teilanmeldung zu der unter INID-Kode 62 erwähnten
Anmeldung eingereicht worden.

(54) **Magnetometer**

(57) Es wird ein Magnetometer mit geschlossenen supraleitenden eine Stromschleife bildende Zellen (23, 24, 26), die jeweils mehrere, vorzugsweise zwei, Josephsonkontakte (28, 29) enthalten, vorgeschlagen, wobei die Zellen (23, 24, 25, 26) einen supraleitenden Quanten-Interferenz-Filter (1, 9, 27) bilden, bei welchen wenigstens drei dieser Zellen supraleitend und/oder nicht supraleitend in Verbindung stehen, die Kontakte der wenigstens drei Zellen derart bestrombar sind, dass jeweils über mindestens zwei Kontakte einer Zelle eine zeitveränderliche Spannung abfällt, deren zeitliches Mittel nicht verschwindet, die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass die Spannungsantwortfunktion in Bezug auf den magnetischen Fluss keine Periodizität mit der Periode $\Phi_0$ besitzt. Erfindungsgemäß ist eine Elektronikeinheit vorgesehen. Außerdem ist der supraleitende Quanten-Interferenz-Filter (27) selbst geometrisch derart ausgebildet, dass eine Messung der räumlichen Ableitung von magnetischen Feldern erster und höherer Ordnung möglich ist.

Fig. 8

**Beschreibung**

Die Erfindung betrifft einen Magnetometer nach dem Oberbegriff des Anspruchs 1.

Stand der Technik

Bislang werden Magnetometer zur hochpräzisen Messung von Magnetfeldern regelmäßig auf der Basis von supraleitenden Quanten-Interferenz-Detektoren (SQUID) aufgebaut. Bei derartigen SQUIDs werden einfach geschlossene supraleitende Stromschlaufen verwendet, welche üblicherweise zwei, in vereinzelten Anwendungen auch mehr Josephsonkontakte enthalten. Sofern diese Stromschlaufen mit einem Strom getrieben werden, der unter einem kritischen Strom liegt, fällt an den Kontakten keine Spannung ab. In der Magnetometer-Anwendung werden die Stromschlaufen jedoch durch einen überkritischen Strom getrieben, so dass zwischen den beiden supraleitenden Elektroden zu beiden Seiten der Kontakte eine sich zeitlich schnell ändernde Wechselspannung abfällt. Die Frequenz dieser Wechselspannung hängt von der Stärke des treibenden Stromes und der Stärke des magnetischen Flusses ab, der die Schlaufe durchsetzt. Als einfach zugängliche Messgröße dient beim Magnetometer die über der Stromschlaufe abfallende Gleichspannung, welche durch zeitliche Mittlung der sich schnell ändernden Wechselspannung über eine oder mehrere Perioden entsteht. Die Eichkurve eines typischen Zwei-Kontakt-DC-SQUID besitzt eine Periodizität mit der Periode $\Phi_0$. $\Phi_0$ ist dabei das elementare Flussquant $\Phi_0 = h/2e$. Immer dann, wenn der Fluss, der die Stromschlaufen durchsetzt, einem ganzzahligen Vielfachen des elementaren Flussquants entspricht, nimmt die Eichkurve ein Minimum an, für halbzahlige Vielfache des elementaren Flussquants $\Phi_0$ hingegen ein Maximum. Die Eichkurven derartiger SQUID-Systeme besitzen eine solche Periodizität. In Magnetometern muss bei sich stärker ändernden magnetischen Feldern bei der Messung die Anzahl der Perioden der Eichkurve des SQUID bestimmt werden, die bei einer Änderung des Magnetfeldes durchlaufen werden. Aus der Anzahl der durchlaufenden Perioden lässt sich dann die Größe der Magnetfeldänderung bestimmen. Das Zählen der Periodendurchläufe ist nicht nur schaltungstechnisch vergleichsweise aufwändig, sondern unterliegt auch im Hinblick auf maximal mögliche Änderungen pro Zeiteinheit einer Begrenzung. Denn sofern das Äußere zu messende magnetische Feld zu schnell ansteigt, kann die Zählung außer Tritt geraten, wodurch die Messung nutzlos wird.

Aufgabe und Vorteile der Erfindung

Der Erfindung liegt die Aufgabe zugrunde, ein Magnetometer insbesondere zur hochpräzisen Messung von Magnetfeldern auf der Grundlage von supraleitenden, geschlossenen Schlaufen, die jeweils mehrere Josephsonkontakte beinhalten sowie mit einer Elektronikeinheit bereitzustellen, mit welchen sich Magnetfeldgradienten im Hinblick auf den Vorrichtungsaufwand vergleichsweise einfacher und insgesamt zuverlässiger bestimmen lassen.

Diese Aufgabe wird durch die Merkmale des Anspruchs 1 gelöst. Die Erfindung geht zunächst von einem Magnetometer, insbesondere zur hochpräzisen Messung von magnetischen Feldern aus, das geschlossene, supraleitende eine Stromschleife bildende Zellen, die jeweils mehrere Josephsonkontakte enthalten sowie eine Elektronikeinheit umfasst. Weiterhin bilden die Zellen einen supraleitenden Quanten-Interferenz-Filter, bei welchem wenigstens drei dieser Zellen supraleitend und/oder nicht supraleitend in Verbindung stehen, die Kontakte der wenigstens drei Zellen derart bestromt werden, dass jeweils über mindestens zwei Kontakte einer Zelle eine zeitveränderliche Spannung abfällt, deren zeitliches Mittel nicht verschwindet, die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass die Spannungsantwortfunktion in Bezug auf den magnetischen Fluss keine Periodizität mit der Periode $\Phi_0$ besitzt, so dass das Frequenzspektrum der Spannungsantwortfunktion in Bezug auf den magnetischen Fluss keinen signifikanten $\Phi_0$-periodischen Anteil besitzt, oder, falls ein diskretes Frequenzspektrum existiert, der Beitrag des $\Phi_0$-periodischen Anteils des diskreten Frequenzspektrums im Vergleich zu den nicht $\Phi_0$-periodischen Anteilen des diskreten Frequenzspektrums nicht dominant ist. Der Kern der Erfindung liegt darin, dass eine Elektronikeinheit vorgesehen ist, und dass der supraleitende Quanten-Interferenz-Filter selbst geometrisch derart ausgelegt ist, dass eine Messung der räumlichen Ableitung von magnetischen Feldern erster oder höherer Ordnung möglich ist.

Diese Variante erfordert in der technologischen Umsetzung supraleitende Überkreuzungen und ist daher vergleichsweise einfacher auf der Basis von Niedertemperatursupraleitern herstellbar, allerdings nicht prinzipiell darauf beschränkt.

Bei weiteren Ausführungsformen ist es außerdem denkbar, Einkoppelstrukturen in Gradiometerform mit einem supraleitenden Quanten-Interferenz-Filter zu kombinieren, der ebenfalls zur Messung eines Magnetfeldgradienten ausgelegt ist. Dies hat den Vorteil, dass die Gesamtanordnung nicht mehr sensitiv gegenüber homogenen Feldern ist. Dadurch wird das sonst durch homogene Magnetfelder erzeugte Messsignal eliminiert.

In einer überdies bevorzugten Ausgestaltung der Erfindung enthält der Magnetometer mehrere supraleitende Quanten-Interferenz-Filter, welche einzeln oder in Gruppen von einer einzelnen oder mehreren Elektronikeinheiten und durch eine einzelne oder mehrere Rückkoppelschlaufen getrennt oder gemeinsam steuerbar sind. Es sind also eine Vielzahl von Strukturvarianten möglich, mit welchen sich ein Präzisionsmagnetometer aufbauen lässt.

Um die Degradation zu verhindern, müssen die einzelnen SQIF-Zellen bzw. SQIF-Schlaufen und die Geometrie des gesamten SQIF wegen der Periodizitätseigenschaften der Einzelschlaufen derart ausgelegt werden, dass die bei Anwesenheit eines äußeren magnetischen Feldes fließenden Abschirmströme in der Mehrzahl der SQIF-Schlaufen keinen magnetischen Fluss erzeugen, welcher größer ist als das elementare Flussquant $\Phi_0$.

Die Begrenzung der von den Abschirmströmen erzeugten magnetischen Felder kann dabei auf unterschiedliche Art und Weise erfolgen. Zunächst kann die Geometrie des SQIF, insbesondere die Leitungsführung und die Leiterbreite bzw. der Leiterquerschnitt sowie die Schlaufengröße mit Hilfe der bekannten elektrotechnischen Verfahren derart berechnet werden, dass die Induktivitäten der einzelnen Schlaufen klein genug sind. Da der maximale supraleitende Abschirmstrom durch die Größe des kritischen Stroms, der durch die Josephsonkontakte fließen kann, gegeben ist, kann mit Hilfe der berechneten Induktivitäten der in den einzelnen Schlaufen induzierte magnetische Fluss bestimmt werden. Ist dieser Fluss zu groß, dann kann er entweder durch Veränderung der Geometrie des SQIF bzw. der SQIF-Schlaufen oder durch die Wahl von Josephsonkontakten, welche kleinere kritische Ströme besitzen, entsprechend reduziert werden.

Im Gegensatz zu den bekannten SQUIDs oder den bekannten periodischen Anordnungen von identischen Schlaufen ist es zur Erzielung einer optimalen Leistungsfähigkeit des Magnetometers bei SQIFs jedoch nicht notwendig, dass bei Anwesenheit eines magnetischen Feldes die Abschirmströme in allen Schlaufen einen magnetischen Fluss erzeugen, welcher kleiner ist als das elementare Flussquant $\Phi_0$. Da sich die magnetischen Abschirmfelder in erfindungsgemäßen SQIFs zumindest teilweise gegenseitig aufheben und durch die unterschiedlichen Schlaufengrößen unterschiedliche induktive Kopplungen zwischen den Schlaufen auftreten, hat es sich herausgestellt, dass es ausreichend ist, wenn in der Mehrzahl der Schlaufen kein magnetischer Fluss erzeugt wird, welcher größer ist als das elementare Flussquant $\Phi_0$. In der praktischen Anwendung ist dies ein großer Vorteil von SQIFs gegenüber bekannten Anordnungen, da die effektive Gesamtfläche und damit die Sensitivität des Magnetometers in einfacher Weise stark gesteigert werden kann.

Vorzugsweise umfasst das Magnetometer Auswertemittel, die z.B. im Magnetometer integriert sind, um die Bestimmung des magnetischen Felds auf der Grundlage des durch die Rückkoppelschlaufe fließenden Stromes automatisiert vornehmen zu können. Durch die Verwendung eines supraleitenden Quanten-Interferenz-Filters lässt sich die Elektronikeinheit im Vergleich zu bekannten Auswerteschaltungen bei Magnetometern deutlich einfacher ausgestalten.

Die oben angegebenen allgemeinen Merkmale eines supraleitenden Quanten-Interferenz-Filters und eine Vielzahl von Konkretisierungen sind aus der DE 100 43 657 A1 bekannt. Auf diese deutsche Offenlegungsschrift soll daher ausdrücklich Bezug genommen werden. Hieraus ist nicht nur die oben beschriebene Grundform eines supraleitenden Quanten-Interferenz-Filters (im Folgenden auch mit SQIF bezeichnet) bekannt, sondern auch eine Vielzahl von Weiterbildungen entsprechend den nachstehenden Ausführungen A1) bis A12) :

A1) Im Hinblick auf die Periodizität der Spannungsantwortfunktion kann für das SQIF auch der folgende funktionale Ansatz gewählt werden: Dass die wenigstens drei Zellen derart geometrisch unterschiedlich ausgestaltet sind, dass die bei einem vorhandenen magnetischen Feld von den Zellen eingeschlossenen magnetischen Flüsse derart in einem Verhältnis zueinander stehen, dass die Periode der Spannungsantwortfunktion des Netzwerks in Bezug auf den die Netzwerkzellen in ihrer Gesamtheit durchsetzenden magnetischen Fluss größer oder sehr viel größer als der Wert eines elementaren Flussquants ist bzw. die Spannungsantwort keinen $\Phi_0$-periodischen Anteil mehr aufweist. Im Idealfall besitzt die Spannungsantwortfunktion keine Periode mehr, wenn die von den Zellen eingeschlossenen magnetischen Flüsse in keinem rationalen Verhältnis zueinander stehen. Vorzugsweise sind zusätzlich die Flächenunterschiede der einzelnen Zellen vergleichsweise groß. Insbesondere in diesem Fall superpositionieren supraleitend verbundene Zellen in einer Weise, dass die Spannungsantwortfunktion keine Periode mehr aufweist. Somit werden gezielt unterschiedliche Zellen miteinander verschaltet, was der Fachmann bei herkömmlichen SQUID-Anordnungen immer vermeiden möchte. Dies kommt beispielsweise in der Veröffentlichung von HANSEN, BINSLEV J., LINDELOF P.E.: Static and dynamic interactions between Josephson junctions. In: Reviews of Modern Physics, Vol. 56, No. 3, July 1984, S. 431 - 459; zum Ausdruck. In dieser Veröffentlichung wird auf S. 434, linke Spalte, letzter Absatz sowie folgend auf der rechten Spalte ein System mit identischen Zellen und identischen Kontakten favorisiert und dagegen Unsymmetrien als kontraproduktiv für die Funktion des diesbezüglich beschriebenen SQUIDs eingestuft.

Supraleitende Quanten-Interferenz-Filter zeigen den physikalischen Effekt der multiplen makroskopischen Quanten-Interferenz auf eine Weise, dass die Mehrdeutigkeit der Eichkurven herkömmlicher SQUID-Magnetometer und -Gradiometer beseitigt wird.

In einem supraleitenden Quanten-Interferenz-Filter interferieren die quantenmechanischen Wellenfunktionen, welche den Zustand des supraleitenden Festkörpers beschreiben, derart, dass eine eindeutige makroskopische Eichkurve $\left\langle V(\vec{B};I_0)\right\rangle$ entsteht. Die Eichkurve $\left\langle V(\vec{B};I_0)\right\rangle$ des supraleitenden Quanten-Interferenz-Filters besitzt im Idealfall keine Periodizität mit der Periode $\Phi_0$ und ist eine in einem bestimmten Messbereich monoton steigende Funktion des Betrags des äußeren magnetischen Feldes $\vec{B}$ am Ort des SQIF.

Die Eindeutigkeit der Eichkurve und die hohe Empfindlichkeit von supraleitenden Quanten-Interferenz-Filtern erlauben die direkte Messung zeitveränderlicher elektromagnetischer Felder in einem kontinuierlichen Frequenzbereich, dessen untere Schranke bei $v_{ext} \approx 0$ und dessen obere Schranke je nach Art der verwendeten Josephsonkontakte oder weak links zur Zeit bei mehreren hundert GHz bis THz liegt. Dieser gesamte Frequenzbereich ist mit einem einzigen entsprechend ausgelegten supraleitenden Quanten-Interferenz-Filter zugänglich. Bei der Detektion elektromagnetischer Wellen operiert der supraleitende Quanten-Interferenz-Filter simultan als Empfangsantenne, Filter und leistungsfähiger Verstärker. Das Eigenrauschen von geeignet ausgelegten Quanten-Interferenz-Filtern kann dabei um mehrere Größenordnungen kleiner sein als das Eigenrauschen konventioneller SQUID-Magnetometer. Ein weiterer Vorteil gegenüber herkömmlichen Antennen und Filtern liegt dabei unter anderem darin, dass bedingt durch das Messprinzip der Frequenzbereich nicht von der räumlichen Ausdehnung des supraleitenden Quanten-Interferenz-Filters abhängt. Die räumliche Ausdehnung kann lediglich die Empfindlichkeit beeinflussen. Die Herstellung von supraleitenden Quanten-Interferenz-Filtern kann nach bekannten kostengünstigen technischen Verfahren erfolgen, wie sie etwa in der modernen Fertigung konventioneller SQUIDs angewandt werden. Da sich die räumliche Ausdehnung von supraleitenden Quanten-Interferenz-Filtern nicht wesentlich von der räumlichen Ausdehnung konventioneller SQUID-Systeme unterscheiden muss, können die für konventionelle SQUID-Systeme entwickelten Kryotechnologien direkt übernommen werden. Spezielle Entwicklungen auf dem Gebiet der Kryotechnologie sind nicht nötig.

A2) Vorzugsweise sind in einem System aus oben beschriebenen Zellen zumindest für eine Zelle, günstigerweise für den größten Teil der Zellen genau zwei Kontakte pro Zelle vorgesehen, welche supraleitend verbunden und elektrisch parallel geschaltet sind. Durch genau zwei Kontakte lassen sich die soeben beschriebenen Effekte vergleichsweise einfach und gut erreichen.

A3) Die gewünschten Effekte lassen sich jedoch auch in günstiger Weise erzielen, wenn in einer Zelle mehr als zwei Kontakte vorgesehen sind, die supraleitend verbunden und elektrisch parallel geschaltet sind, und zwar in Form einer Serienschaltung von Kontakten, die mit einem Einzelkontakt parallel geschaltet ist, oder in Form von zwei parallel geschalteten Serienschaltungen von Kontakten.

A4) Die erfindungsgemäßen Effekte lassen sich jedoch auch durch Strukturen wenigstens einer Zelle eines Netzwerks erreichen, bei denen neben einer Grundform von mindestens zwei Kontakten, an welchen eine im zeitlichen Mittel nicht verschwindende, zeitveränderliche Spannung abfällt, insbesondere neben einer Grundform von zwei elektrisch parallel geschalteten Kontakten, ein weiterer Kontakt oder mehrere weitere Kontakte vorgesehen sind, welche Kontakte nicht direkt bestromt werden und daher an diesen Kontakten im Mittel keine Spannung abfällt. Die Verbindungen aller Kontakte in den einzelnen Zellen ist dabei weiterhin supraleitend. Solche Ausführungsformen können von Vorteil sein, da durch zusätzliche Kontakte die von einem magnetischen Feld in den einzelnen Zellen induzierten Abschirmströme reduziert werden können. Der Einfluss von Eigen- und Gegeninduktivitäten kann dadurch vermindert werden.

A5) In einer besonders bevorzugten Ausführungsform bilden mehrere Zellen ein Netzwerk oder einen Netzwerkabschnitt, in welchem alle Kontakte elektrisch parallel geschaltet sind, so dass die Kontakte gleich gerichtet bestrombar sind. Insbesondere, wenn in diesem Zusammenhang die Zellen supraleitend miteinander in Verbindung stehen, lassen sich durch eine derartige Anordnung besonders große Empfindlichkeiten für die Messung eines Magnetfeldes erzielen.

A6) Mehrere Zellen oder Netzwerkabschnitte lassen sich vorteilhafterweise jedoch auch elektrisch in Reihe schalten, so dass wiederum die Kontakte im Netzwerk in der gleichen Richtung bestrombar sind. Durch diese Maßnahme kann die Größe des Messsignals erhöht werden, da sich in der Reihenschaltung die Spannungen an den Kontakten addieren.

A7) Eine besonders hohe Empfindlichkeit kann auch durch die Parallelschaltung von Serienanordnungen mehrerer Zellen oder Netzwerkabschnitte erreicht werden. Vorzugsweise sind in dieser Ausführungsform die Netzwerkabschnitte oder Zellen supraleitend verschaltet, insbesondere durch supraleitende twisted-pair-Kabel. Das Auflösungsvermögen von supraleitenden Quanten-Interferenz-Filtern kann dabei bis in den Bereich von aT (10-18 Tesla) und darunter reichen. Die Eichkurve bleibt auch für solche Messbereiche eindeutig, so dass absolute quantitative Messungen von extrem kleinen Feldern möglich werden.

A8) Das Netzwerk kann spannungsgetrieben oder stromgetrieben eingesetzt werden.

A9) Um möglichst ideale Josephson-Effekte zu erzielen, wird überdies vorgeschlagen, dass die Kontakte als Punktkontakte ausgeführt sind.

A10) Um die Empfindlichkeit eines SQIF zu erhöhen, kann außerdem die Geometrie der Zellenanordnung derart ausgeführt werden, dass ein magnetisches Übersprechen einer Zelle auf eine benachbarte Zelle aufgrund des durch einen in den Zellen fließenden Stroms hervorgerufenen magnetischen Eigenfeldes reduziert wird.

A11) In einer weiteren bevorzugten Ausgestaltung sind die Zellen des Netzwerkes und/oder Netzwerkabschnitte räumlich, insbesondere räumlich zwei- oder dreidimensional ausgerichtet. Durch diese Maßnahme wird es möglich, zusätzlich zum Betrag des Magnetfeldes einzelne Magnetfeldkomponenten zu bestimmen. Bei einer räumlich dreidimensionalen Anordnung lässt sich somit die Richtung des Magnetfelds messen.

A12) Im Weiteren ist es bevorzugt, wenn der die Kontakte treibende Strom durch ohmsche Widerstände, welche insbesondere als bus-bar-Widerstände ausgeführt sind, eingespeist und/oder wieder abgeführt wird. Denn Messungen haben gezeigt, dass die Einspeisung des treibenden Stroms durch ohmsche Widerstände die Performance des SQIF erheblich verbessern kann.

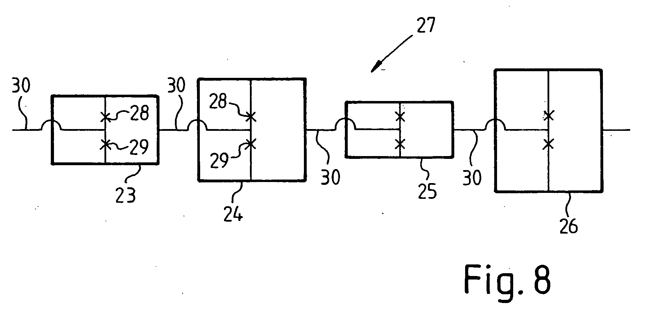

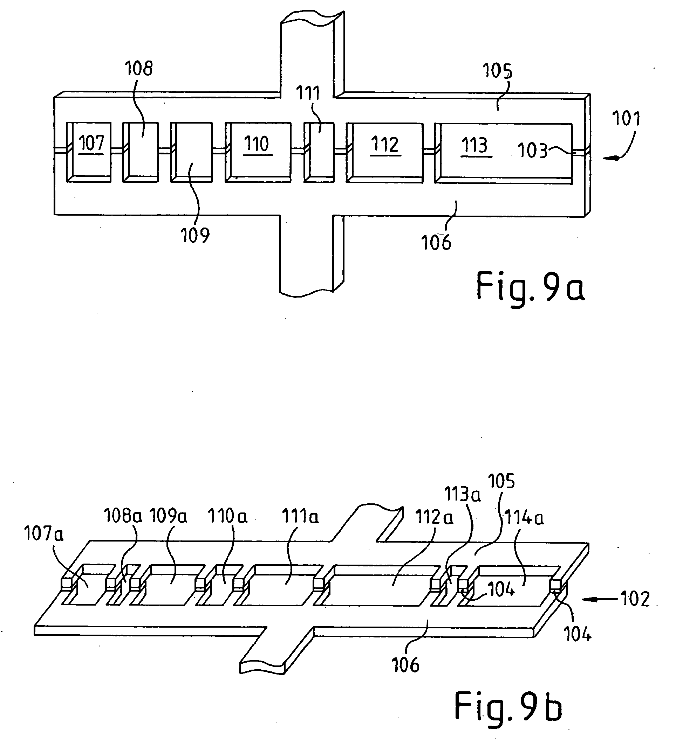

Für weitere Ausgestaltungen von SQIFs wird auf die Figuren 9a bis 20 und deren dazugehörigen Beschreibungsteile im Anschluss an die Figurenbeschreibung zu den Figuren 1 bis 8 verwiesen.

Der Einsatz von einem supraleitenden Quanten-Interferenz-Filter hat im Weiteren den Vorteil, dass derartige Filter einen im Vergleich zu bekannten SQUID größeren Spannungshub besitzen. Hierdurch wird die Gefahr, dass der Messbereich verlassen wird, reduziert. Außerdem wird der Einfluss von Rauschen auf die Messung vermindert. Durch den Einsatz eines supraleitenden Quanten-Interferenz-Filters mit einer eindeutigen Spannungsantwortfunktion lässt sich nach einem Verlassen des Arbeitsbereichs des Magnetometers aufgrund der Eindeutigkeit der ursprüngliche Arbeitspunkt wieder auffinden, wodurch weitere Messungen fehlerfrei an die vorangehenden Messungen anschließen können.

Für ein Magnetometer lassen sich eine Vielzahl von unterschiedlichen Ausgestaltungen eines supraleitenden Quanten-Interferenz-Filters verwenden. Alle supraleitenden Quanten-Interferenz-Filter umfassen, wie bereits oben beschrieben, verschieden große supraleitende Zellen bzw. Schleifen mit mehreren Josephsonkontakten. Einige besonders vorteilhafte hierauf aufgebaute Strukturen von supraleitenden Quanten-Interferenz-Filtern sind nachfolgend beschrieben:

B1) Bei einer ersten Ausführungsform sind die supraleitenden Schleifen in Serie angeordnet. Hierdurch addieren sich die Spannungshübe der einzelnen Schleifen, woraus ein größerer Messbereich um den Arbeitspunkt resultiert. Ein weiterer Vorteil besteht darin, dass das Eigenrauschen der Anordnung gegenüber einer einzelnen Schleife um den Faktor $\sqrt{N}$ verringert wird ($N$ ist gleich die Anzahl der Schleifen). Dies bringt eine entsprechende Verbesserung der rauschbegrenzten Magnetfeldempfindlichkeit. Insbesondere bei hochtemperatursupraleitenden Anordnungen werden sehr kleine kritische Ströme der Josephsonkontakte eingestellt. Dadurch wird gesichert, dass beim verwendeten Betriebsstrom des supraleitenden Quanten-Interferenz-Filters (Betriebsstrom ist gleich der Strom, bei dem ein unikaler Spannungspeak der nicht periodischen Eichkurze am besten ausgeprägt ist) möglichst viele der Einzelschleifen zusammenarbeiten. Dies trägt dem Umstand Rechnung, dass insbesondere bei hochtemperatursupraleitenden Josephsonschaltungen, die kritischen Ströme von mehreren Josephsonkontakten in einem bestimmten Bereich streuen. Bei kleinen kritischen Strömen treten zwei für den Betrieb des supraleitenden Quanten-Interferenz-Filters günstige Umstände auf: Zum einen überlappen die Arbeitsbereiche der einzelnen Kontakte bei gleicher relativer Streuung der kritischen Ströme umso mehr, je kleiner ihre absolute Größe ist. Zum anderen tritt bei kleinen kritischen Strömen eine verstärkte Rauschverrundung auf, welche die Arbeitsbereiche der einzelnen Kontakte noch weiter vergrößert.

B2) Die Schleifen des supraleitenden Quanten-Interferenz-Filters lassen sich auch parallel schalten. Bei gleichem Spannungshub wie bei einer einzelnen Schleife wird hier die Empfindlichkeit gegenüber einem äußeren Magnetfeld entsprechend der Anzahl der Schleifen erhöht. Daraus resultiert eine ebensolche Verringerung des Eigenrauschens im Vergleich zu einer einzelnen Schleife so wie bei der Serienanordnung, wodurch ebenfalls eine entsprechende Verbesserung der rauschbegrenzten Magnetfeldempfindlichkeit erreicht wird. Die Parallelanordnung ist insbesondere auch bei einer Realisierung auf der Grundlage von Hochtemperatursupraleitern vorteilhaft. Im Gegensatz zur Serienanordnung stellen sich die Arbeitspunkte der einzelnen Schleifen automatisch richtig ein, man benötigt also keine gezielte Einstellung niedriger kritischer Ströme. Dies ist deshalb so, weil im Gegensatz zu den kritischen Strömen $I_c$ das Produkt $I_c R_n$ mehrer Josephsonkontakte nur sehr wenig streut. Hierbei ist $R_n$ der Betriebswiderstand des Josephsonkontakts. Bei einer Parallelschaltung von Josephsonkontakten teilt sich der Betriebsstrom umgekehrt proportional zu den Betriebswiderständen auf. Daher erhält jeder Josephsonkontakt den Strom, den er braucht, um in seinem optimalen Arbeitsbereich betrieben werden zu können.

B3) Eine weitere vorteilhafte Ausführungsform besteht in der Kombination einer parallelen und seriellen Anordnung von Schleifen. Diese Anordnung besteht z.B. aus einer Reihenschaltung mehrerer Parallelanordnungen von Schleifen. Vorzugsweise findet sich in der Gesamtanordnung aller Schleifen die gleiche Schleifenverteilung wie bei der reinen Serien- oder Parallelanordnung wieder. Die parallel-serielle Anordnung vereint die Vorteile einer Reihen- und Parallelschaltung. Die Parallelschleifen sichern die Einstellung des optimalen Betriebsstromes für alle Schleifen, aus der Serienanordnung resultiert ein größerer Spannungshub. Die Verbesserung der rauschbegrenzten Magnetfeldempfindlichkeit tritt auch hier ein. Die parallel-serielle Anordnung hat noch einen weiteren Vorteil in der praktischen Anwendung. Durch geeignete Wahl der Zahl von Schleifen in der Parallelanordnung und in Reihe geschalteter solcher Parallelanordnungen kann man den Gesamtbetriebswiderstand des supraleitenden Quanten-Interferenz-Filters einstellen, so dass er an eine äußere Elektronik angepasst werden kann.

<u>Zeichnungen</u>

Mehrere Ausführungsbeispiele der Erfindung sind in den Zeichnungen dargestellt und unter Angabe weiterer Vorteile und Einzelheiten näher erläutert.
Es zeigen

Fig. 8                  die schematische Darstellung von Schleifen eines supraleitenden Quanten-Interferenz-Filters, die zur Messung von Feldgradienten ausgelegt sind,

Fig. 9a und b            ein mehrzelliges SQIF aus parallel geschalteten Josephsonkontakten in räumlicher Darstellung,

Fig. 10                das Schaltbild eines äquivalenten supraleitenden Stromkreises eines Quanten-Interferenz-Filters mit $N = 10$ Kontakten,

Fig. 10a bis f        Schaltbilder von weiteren supraleitenden Stromkreisen,

Fig. 11                eine Spannungsantwortfunktion für einen SQIF mit $N = 30$ Kontakten,

Fig. 12a und b        periodische Spannungsantwortfunktionen für herkömmliche SQUIDs,

Fig. 12c              die Spannungsantwortfunktion eines supraleitenden Quanten-Interferenz-Filters,

Fig. 12d              die Spannungsantwortfunktion eines SQUID und eines SQIF,

Fig. 13                eine symbolisch dargestellte räumliche Anordnung eines supraleitenden Quanten-Interferenz-Filters mit angedeuteter vektorieller Basis des dreidimensionalen Raumes,

Fig. 14                ein schematisch dargestelltes, ebenes supraleitendes Quanten-Interferenz-Filter mit einer Magnetfeldkompensationseinrichtung,

Fig. 15                ein supraleitendes Quanten-Interferenz-Filter mit einer parallel geschalteten Steuerleitung in schematischer Ansicht,

Fig. 16                eine schematisch dargestellte Vernetzung von SQIF-Abschnitten,

Fig. 17a bis c        schematisch dargestellte, ebene, supraleitende Quanten-Interferenz-Filter mit einer geometrischen Anordnung zur Minimierung des Einflusses von Eigenfeldern,

Fig. 18a        ein Netzwerk aus in Serie geschalteten Zellen,

Fig. 18b        eine zu einem Netzwerk gemäß Fig. 18a entsprechende Spannungsantwortfunktion bei einer Serienschaltung für $N$ = 100 Zellen,

Fig. 18c        eine Stromspannungskennlinie eines Netzwerks gemäß Fig. 18a, wenn es als Stromverstärker mit Hilfe eines Kompensationsstromkreises betrieben wird,

Fig. 19a        im oberen Bild die typische Spannungsantwortfunktion eines herkömmlichen SQUID mit dem zugehörigen Frequenzspektrum im unteren Bild,

Fig. 19b        im oberen Bild eine typische Spannungsantwortfunktion eines Netzwerks aus identischen Zellen und das zugehörige Frequenzspektrum im unteren Bild,

Fig. 19c        im oberen Bild die Spannungsantwortfunktion eines supraleitenden Quanten-Interferenz-Filters ohne Periodizität und das dazugehörige Spektrum im unteren Bild,

Fig. 19d        im oberen Bild eine Spannungsantwortfunktion und im unteren Bild das zugehörige Spektrum eines Quanten-Interferenz-Filters, welcher eine technisch bedingte, vergleichsweise große Periodizität besitzt und

Fig. 20        ein schematisch dargestelltes, ebenes supraleitendes Quanten-Interferenz-Filter mit einer das primäre magnetische Feld am Ort des Filters verstärkenden supraleitenden Einkoppelschlaufe (pick-up-loop).

Bei einer besonders bevorzugten Ausführungsform der Erfindung sind, wie in Fig. 8 dargestellt, einzelne, hier beispielhaft alle Schlaufen 23 bis 26 eines SQIF 27 selbst als Gradiometerschlaufen ausgeführt. Bei homogenem magnetischen Feld fließt durch die Josephsonkontakte 28, 29 des magnetischen Felds kein Abschirmstrom, d.h. der Spannungsabfall am SQIF ändert sich nicht. Bei einem Feldgradienten fließen Abschirmströme, wodurch eine Spannungsänderung am SQIF 27 auftritt, die proportional zum anliegenden Feldgradienten ist. Die einzelnen Schlaufen 22, 26 sind über Leitungen 30 miteinander verbunden, um den SQIF 27 auszubilden.

Die in Fig. 9 skizzierten Ausführungsbeispiele für einen SQIF werden im Folgenden näher erläutert. Die Abbildungen gemäß Fig. 9a und 9b zeigen die physikalischen Realisierungen von einfachen Mehrschlaufen-Netzwerken 101, 102 mit Josephsonkontakten 103, 104, deren Geometrie und Detektionsverhalten supraleitende Quanten-Interferenz-Filter konstituieren. Die Netzwerke 101, 102 bestehen aus supraleitenden Bereichen 105, 106, die durch die Josephsonkontakte 103, 104 miteinander verbunden sind. Die supraleitenden Bereiche können dabei sowohl aus tieftemperatur-supraleitenden Materialen als auch aus hochtemperatur-supraleitenden Materialien bestehen. Auch von der speziellen Ausführung der Josephsonkontakte (z.B. breakjunctions, step-junctions, Mikrobrücken etc.) hängt die Funktionsfähigkeit des Netzwerks nicht ab. Die quantitativen Angaben zu den Ausführungsbeispielen beziehen sich beispielhaft auf die Parameterspezifikationen der dem Stand der Technik entsprechenden typischen Josephsonkontakte aus konventionellen Supraleitern, zum Beispiel solche mit der $Nb/Al0_x/Nb$-Technologie hergestellten Josephsonkontakten, wie sie in herkömmlichen SQUID-Magnetometer zum Einsatz kommen. Solche Kontakte besitzen typische kritische Ströme $i_c$ von etwa 200 $\mu$ A und einen Normalwiderstand $r_n$, der durch einen extern parallelgeschalteten Ohmschen Widerstand definiert ist von z.B. etwa 1$\Omega$, sowie eine geometrische shunt-Kapazität $c_n$ im Bereich von Pikofarad. Die räumliche Ausdehnung des Netzwerks kann vergleichbar mit der herkömmlicher SQUIDs sein. Die Abmessungen der Zellen der Netzwerke liegen dann im Bereich von $\mu$m bis mm. SQIF-Netzwerke können je nach Anwendung aber auch Zellen mit größeren oder kleineren Abmessungen aufweisen.

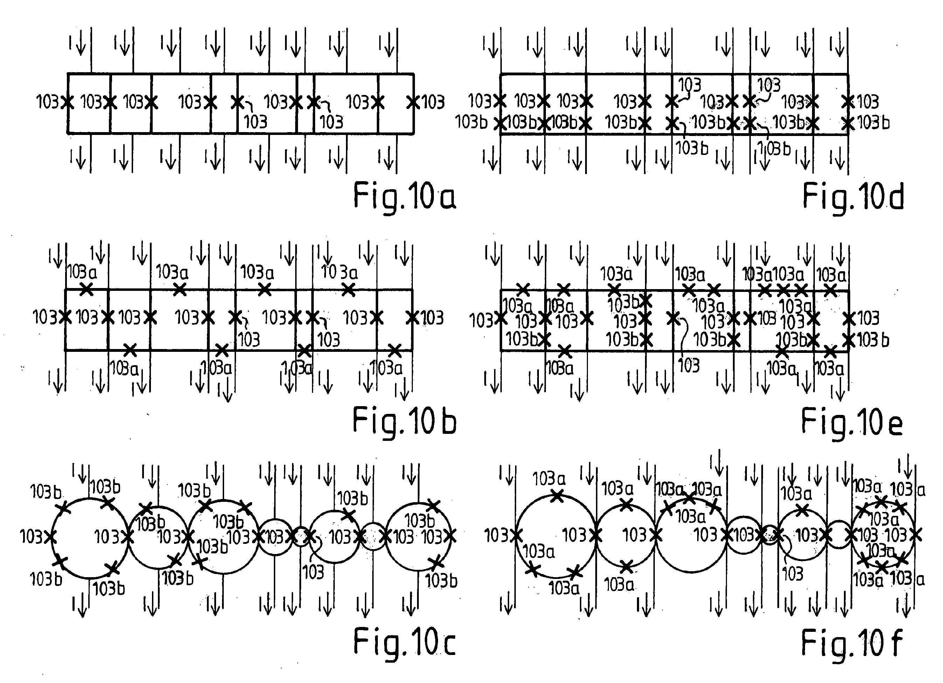

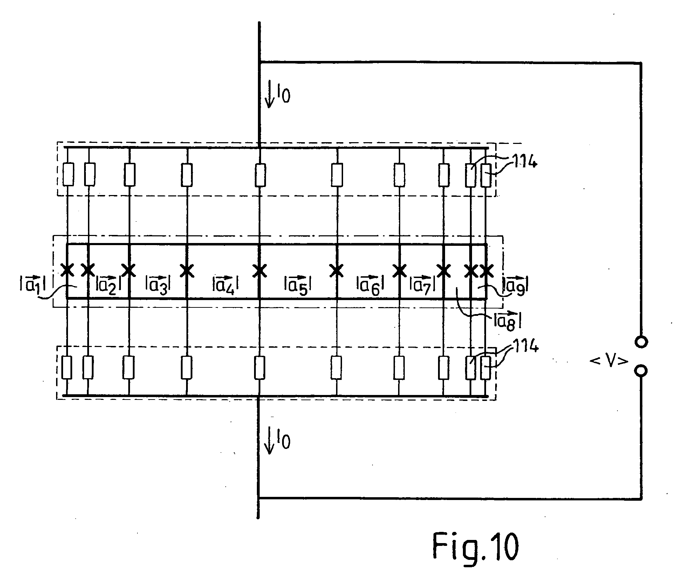

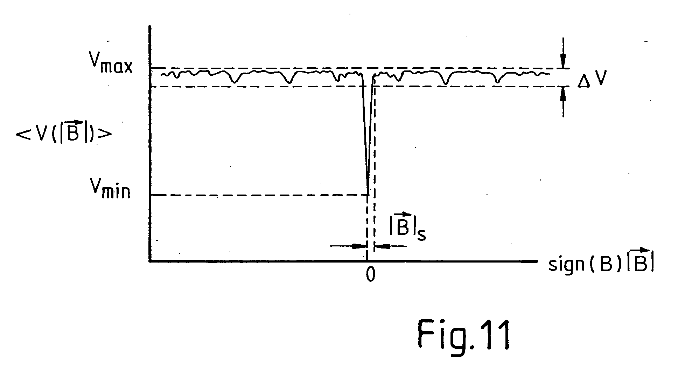

In den Fig. 9a und 9b wird der supraleitende Quanten-Interferenz-Filter konstituiert durch ein ebenes Netzwerk 101, 102 aus den Josephsonkontakten 103, 104, das Zellen 107 bis 113 bzw. 107a bis 114a besitzt, welche jeweils zwei Kontakte in Stromrichtung besitzen. Das Schaltbild des äquivalenten supraleitenden Stromkreises eines SQIF mit $N$ = 10 Kontakten ist in Fig. 10 dargestellt. Das Netzwerk ist dadurch gekennzeichnet, dass die einzelnen Flächen der Zellen 101 bis 109 eine unterschiedliche Größe besitzen und die Flächeninhalte $|a_j|$ der verschiedenen Netzwerkzellen in keinem rationalen Verhältnis zueinander stehen. Mit 114 sind Ersatzwiderstände bezeichnet. Das Kreuz kennzeichnet die Josephsonkontakten 101 bis 110. Durch den strichpunktierten Kasten um die Josephsonkontakte wird der supraleitend verbundene Bereich verdeutlicht. Die fett durchgezogenen Linien innerhalb dieses Kastens symbolisieren supraleitende Verbindungen. Insbesondere unter diesen Voraussetzungen entsteht der physikalische Effekt der multiplen makroskopischen Quanten-Interferenz derart, dass die quantenmechanischen Wellenfunktionen, welche den Zustand der einzelnen supraleitenden Bereiche des Netzwerks beschreiben, nur dann konstruktiv interferieren, wenn der das Netzwerk durchsetzende magnetische Fluss identisch verschwindet. Der makroskopische Gesamtzustand des Netzwerks kann dadurch ausgelesen werden, dass das Netzwerk durch einen konstanten oder einen zeitveränderlichen überkritischen Strom $I_0$ getrieben wird. Dann ergibt sich eine Spannungsantwortfunktion $\left\langle V(\vec{B};I_0)\right\rangle$, die nur ein globales absolutes Minimum bei $|\vec{B}|=0$ besitzt und bei anwachsendem $|\vec{B}|$ monoton ansteigt, bis schließlich ein annähernd konstant bleibender Wert $V_{\max}(\vec{B};I_0)$ erreicht wird, der sich bei weiter anwachsendem $|\vec{B}|$ nicht mehr wesentlich ändert, wie dies in Fig. 11 für ein Netzwerk mit $N$ = 30 Kontakten schematisch dargestellt ist. Für ein am Ort des Netzwerks vorhandenes magnetisches Feld $\vec{B}$ mit $0<|\vec{B}|<|\vec{B}|_s$ ist die Spannungsantwortfunktion des supraleitenden Quanten-Interferenz-Filters daher eindeutig. Für $|\vec{B}|>|\vec{B}|_s$ ergibt sich eine nahe bei $V_{\max}$ schwankende Spannungsantwort, deren Varianz mit anwachsendem $N$ schnell kleiner wird, wobei $V_{\max}$ das globale absolute Maximum der Spannungsantwortfunktion ist (vgl. Fig. 11). Der Messbereich des supraleitenden Quanten-Interferenz-Filters wird bestimmt durch den Abstand zwischen dem globalen Minimum $V_{\min}=\left\langle V(|\vec{B}|=0;I_0)\right\rangle$ und $V_{\max}$-$\Delta V$, wobei $\Delta V$ den Abstand zwischen dem kleinsten lokalen Minimum für $|\vec{B}|>|\vec{B}|_s$ und $V_{\max}$ bezeichnet. Der Wert $|\vec{B}|=0$ definiert damit die untere Grenze des Messbereichs und der Wert von $|\vec{B}|$, an dem die Spannungsantwort den Wert $V_{\max}$-$\Delta V$ erreicht, definiert die obere Grenze $|\vec{B}|_s$ des Messbereichs (vgl. Fig. 11). Die Größe von $\Delta V$ hängt dabei von der Zahl der Zellen, welche das Netzwerk besitzt, und von der Wahl der Flächeninhalte der einzelnen Netzwerkzellen, bzw. von deren Verhältnissen zueinander ab. Dies wird in der im nächsten Absatz folgenden theoretischen Beschreibung des supraleitenden Quanten-Interferenz-Filters näher erläutert.

In den Fig. 10b bis f sind Ausführungsformen von Netzwerken skizziert, bei welchen die einzelnen Netzwerkzellen zusätzlich zu den zwei funktional notwendigen Kontakten 103 gemäß Fig. 10a einen weiteren Kontakt oder mehrere weitere Kontakte umfassen. Die Kontakte sind dabei als Kreuze gekennzeichnet. Die dick durchgezogenen Linien kennzeichnen supraleitende Verbindungen. Die dünn durchgezogenen Linien können normalleitend oder supraleitend sein. Die zusätzlichen Kontakte können dabei derart in den einzelnen Netzwerkzellen angebracht werden, dass durch sie kein oder nur ein geringer Teil des treibenden Stroms fließt (nicht direkt bestromte Kontakte 103a) und im Mittel auch keine zeitveränderliche Spannung abfällt. Durch solche Ausführungsformen können die von einem magnetischen Feld in den einzelnen Zellen induzierten Abschirmströme reduziert werden. Des Weiteren kann daher der Einfluss von Eigen- und Gegeninduktivitäten dadurch vermindert werden. Die zusätzlichen Kontakte können jedoch auch so angebracht sein, dass sie vom treibenden Strom I durchflossen werden (direkt bestromte Kontakte 103b). Auch eine Kombination von einem Kontakt 103a oder mehreren Kontakten 103a und einem Kontakt 103b oder mehreren Kontakten 103b in einzelnen oder mehreren Zellen des Netzwerks ist möglich.

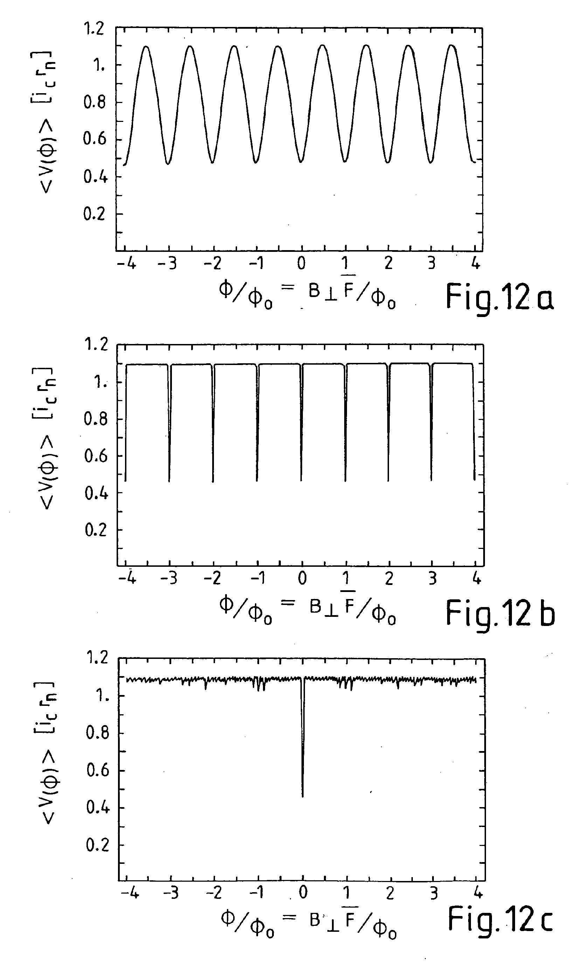

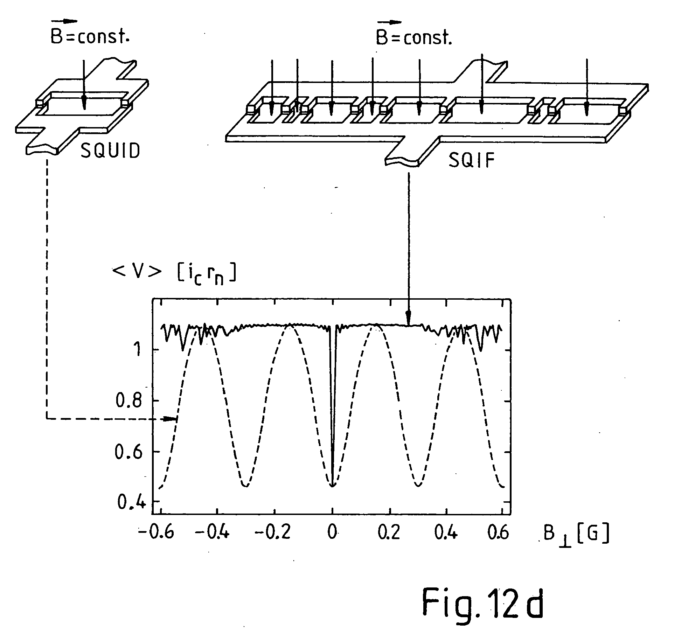

In den Fig. 12a bis 12c ist zum direkten Vergleich die Spannungsantwortfunktion eines konventionellen Einschlaufen-SQUIDs (Fig. 12a), eines konventionellen Mehrschlaufen-SQUID mit regelmäßigen Einheitszellen identischer Größe (Fig. 12b) und eines supraleitenden Quanten-Interferenz-Filters (Fig. 12c) dargestellt. Besagtes Beispiel zum Einschlaufen-SQUID besteht aus einer einzelnen supraleitenden Schlaufe bzw. Zelle mit zwei Josephsonkontakten, der Mehrschlaufen-SQUID aus einer Parallelanordnung solcher identischer Einschlaufen-SQUIDs ("Leiterarray") mit $N$ =30 Kontakten, und der supraleitende Quanten-Interferenz-Filter besitzt ebenfalls $N$ =30 Kontakte. Der treibende Strom $I_0$ ist für alle drei Anordnungen so gewählt, dass für $|\vec{B}|=0$ der Strom pro Kontakt den Wert 1.1 $i_c$ besitzt, so dass der Spannungshub $V_{\max}$-$V_{\min}$ für alle drei Vorrichtungen gleich ist. In Fig. 12d sind die Spannungsantwortfunktionen eines konventionellen SQUIDs und eines SQIFS noch einmal anhand eines konkreten Ausführungsbeispiels dargestellt. Während Einschlaufen-SQUIDs und Mehrschlaufen-SQUIDs eine periodische Spannungsantwortfunktion $\langle V\rangle$ mit der Periode $\Phi_0$ derart besitzen, dass keine absolute Messung des magnetischen Feldes möglich ist, besitzt der ebene supraleitende Quanten-Interferenz-Filter eine eindeutige Spannungsantwortfunktion. Diese Spannungsantwortfunktion des SQIFs ermöglicht dadurch die absolute quantitative Messung des magnetischen Feldes. Im gewählten Beispiel liegt der Messbereich zwischen $\Phi=0$ und $\Phi=B_\perp\bar{F}\approx0.02\Phi_0$. Bei einer mittleren Netzwerkzellenfläche $\bar{F}$ im Bereich von $\mu m_2$ entspricht dies Magnetfeldstärken zwischen $B_{\parallel}=0$ und $B_{\parallel}$=10-4 T und für $\bar{F}$ im Bereich von $mm_2$ Magnetfeldstärken zwischen $B_{\parallel}$=0 T und $B_{\parallel}$=10-10 T. Die Auflösungsgrenze kann bei diesen Beispielen im Bereich von 10-13 T bis 10-16 T liegen.

Durch Verwendung einer Kompensationsschaltung, mit deren Hilfe ein magnetischer Fluss bekannter Stärke kontrolliert in den supraleitenden Quanten-Interferenz-Filter eingekoppelt werden kann, lässt sich der Messbereich der erfindungsgemäßen Vorrichtung bei gleichbleibender Empfindlichkeit beliebig variieren.

Die elektrotechnische theoretische Beschreibung des supraleitenden Quanten-Interferenz-Filters kann mit Hilfe des sogenannten RCSJ -Modells (RCSJ = resistively and capacitively shunted junction) für die einzelnen Josephsonkontakte unter Berücksichtigung der Netzwerktheorie für supraleitende Schaltungen erfolgen. Im RCSJ-Modell wird der einzelne Josephsonkontakt durch eine nichtlineare Induktivität beschrieben, der ein ohmscher shunt-Widerstand $r_n$ und eine geometrische, die Tunnelbarriere charakterisierende shunt-Kapazität $c_n$ parallelgeschaltet sind. Die Beschreibung des makroskopischen Zustands der Josephsonkontakte erfolgt durch die eichinvariante Differenz der makroskopischen quantenmechanischen Phasen an den beiden gegenüberliegenden supraleitenden Elektroden des jeweiligen Kontakts. Diese Phasendifferenz wird mit $\phi_j$ bezeichnet, wobei $j=1...N$ die einzelnen Kontakte des Netzwerks indiziert. Die der Netzwerkdynamik zugrundeliegenden Relationen sind dann durch

$$I_j = i_c \sin(\phi_j) + \frac{v_j(t)}{r_n} + c_n \, \partial_t v_j(t), \qquad (1)$$

$$v_j(t) = \frac{\hbar}{2e}\partial_t \phi_j, \qquad (2)$$

$$\phi_{j+1} - \phi_j = 2\pi \, \frac{\Phi_j}{\Phi_0} \qquad (3)$$

gegeben, wobei $I_j$ den durch den Kontakt mit Index $j$ fließenden Strom mit $\Sigma_{j=1}^{N} I_j = I_0$ und $\Phi_j$ den die Netzwerkzelle mit Index j durchsetzenden magnetischen Fluss bezeichnet. Gleichung 1 beschreibt die nichtlineare Relation zwischen dem Strom $I_j$ und der über dem Kontakt abfallenden Spannung $v_j(t)$ im RCSJ Modell. Gleichung 2 entspricht der zweiten Josephson-Relation, nach der die über dem Kontakt abfallende Spannung $v_j(t)$ direkt proportional der zeitlichen Ableitung $\partial_t \phi_j$ der Phasendifferenz $\phi_j$ ist. Gleichung 3 ist Ausdruck der Quantisierung des magnetischen Flusses durch eine geschlossene supraleitende Schlaufe.

Der Einfachheit halber wird bei der theoretischen Beschreibung angenommen, dass die Netzwerkkontakte identisch sind, d.h. dass sowohl die kritischen Ströme $i_c$ als auch die parallelgeschalteten shunt-Widerstände $r_n$ und shunt-Kapazitäten $c_n$ nicht statistisch oder systematisch streuen.

Das Auftreten von typischen fertigungsbedingten Parameterstreuungen beeinträchtigt die Funktionsfähigkeit des supraleitenden Quanten-Interferenz-Filters jedoch nicht. Die theoretische Beschreibung im Rahmen des RCSJ-Modells beschränkt sich zudem auf sogenannte Punktkontakte, d.h. auf Kontakte, die so klein sind, dass die Phasendifferenzen über die Ausdehnung der Kontaktbarriere nicht variieren. Dies ist eine auch bei der theoretischen Beschreibung konventioneller SQUIDs übliche Annahme. Bei supraleitenden Quanten-Interferenz-Filtern ist diese Annahme in besonderer Weise gerechtfertigt, da im Gegensatz zu konventionellen SQUIDs die auftretenden Interferenzmuster mit wachsender Zahl der Netzwerkzellen von der Netzwerkdynamik dominiert werden und daher nur äußerst schwach von der speziellen Geometrie der einzelnen Kontakte abhängen.

Die aus der Stromerhaltung und den Gleichungen 1 bis 3 folgenden Netzwerkgleichungen verknüpfen das am Ort des Netzwerks wirkende Magnetfeld $\vec{B}$ und den treibenden Strom $I_0$ mit der über der Schaltung abfallenden Spannung V(t). Für statische oder im Vergleich zur Netzwerkfrequenz langsam variierende Magnetfelder $\vec{B}$ kann die Netzwerkgleichung für den SQIF dieses Ausführungsbeispiels und allgemein für SQIFs, die aus parallel geschalteten Netzwerkzellen bestehen, als nichtlineare Differentialgleichung der Form

$$\frac{\hbar}{2e}\frac{c_n}{i_c}\partial_t^2 \phi_1 + \frac{\hbar}{2e\, i_c\, r_n} \partial_t \phi_1 + \left|S_N(\vec{B})\right| \sin(\phi_1 + \delta_N) = \frac{I_0}{N i_c} \qquad (4)$$

$$v_1(t) = \frac{\hbar}{2e} \partial_t \phi_1 \qquad\qquad (5)$$

geschrieben werden, wobei sich das Magnetfeld $\vec{B} = \vec{B}_{ext} + \vec{B}_c$ aus dem zu messenden, primärem äußeren Feld $\vec{B}_{ext}$ und eventuell einem kontrolliert erzeugten, sekundären magnetischen Kompensationsfeld $\vec{B}_c$ zusammensetzt.

Der in Gleichung 4 auftretende komplexe $(i = \sqrt{-1})$ Strukturfaktor $S_N(\vec{B}) = \left|S_N(\vec{B})\right| \exp\left[i\,\delta_N(\vec{B})\right]$ beschreibt die geometrischen und dynamischen Eigenschaften des aus N-1 Zellen zusammengesetzten supraleitenden Quanten-Interferenz-Filters. Er bestimmt die räumlichen und zeitlichen Interferenzeigenschaften des Netzwerks in Abhängigkeit von der Stärke des zu messenden Magnetfelds. Die Phasenverschiebung $\delta_N$ hängt ebenfalls von der speziellen Geometrie der Anordnung ab, hat jedoch keinen Einfluss auf die zeitlich gemittelte Spannungsantwortfunktion $\left\langle V(\vec{B};I_0) \right\rangle$.

Der komplexe Strukturfaktor $S_N(\vec{B})$ ist zu

$$S_N(B) = \frac{1}{N} \sum_{n=0}^{N-1} \exp\left(\frac{2\pi i}{\Phi_0} \sum_{m=0}^{n} \left\langle \vec{B}, \vec{a}_m \right\rangle\right) \qquad\qquad (6)$$

definiert, wobei die Vektoren $\vec{a}_m$ die orientierten Flächenelemente ( $\frac{\vec{a}_m}{|\vec{a}_m|}$ = Flächennormale, $\left|\vec{a}_m\right|$ = Flächeninhalt der m-ten Schlaufe) der einzelnen Netzwerkschlaufen bezeichnen und $\vec{a}_0 = 0$ gilt. Für den die einzelnen Netzwerkschlaufen durchsetzenden magnetischen Fluss gilt damit $\Phi_m = \left\langle \vec{B}, \vec{a}_m \right\rangle$, wobei für zwei beliebige Vektoren $\vec{a}, \vec{b}$ das Skalarprodukt durch $\left\langle \vec{a}, \vec{b} \right\rangle = |\vec{a}||\vec{b}|\cos\angle(\vec{a}, \vec{b})$ definiert ist. Variiert das Magnetfeld $\vec{B}$ über die Ausdehnung der Schlaufe, dann tritt an die Stelle dieses Skalarprodukts die entsprechende Integraldarstellung. Die Periodizität des Netzwerks wird durch die akkumulierten magnetischen Flüsse

$$\alpha_n = \sum_{m=0}^{n} \left\langle \vec{B}, \vec{a}_m \right\rangle \qquad\qquad (7)$$

mit $n = 0...N\text{-}1$ bestimmt.

Für konventionelle Einschlaufen-SQUIDs, bei denen nur eine orientierte Fläche $\vec{a}_1$ existiert, nimmt $S_N$ mit $N$ = 2 den Wert $S_2 = \frac{1}{2}\left(1 + \exp\left[\frac{2\pi i}{\Phi_0}\Phi\right]\right)$ und $\left|S_2\right| = \cos\left(\frac{\pi\Phi}{\Phi_0}\right)$ an. Für ebene periodische Mehrschlaufen-SQUIDs mit identischen Schlaufenflächen $\vec{a}_1 = \vec{a}_2 = \vec{a}_3 = ... = \vec{a}_{N-1}$ ist $\alpha_n = n\Phi$ mit $\Phi = B_\perp\left|\vec{a}_1\right|$, so dass $S_N = \frac{1}{N}\sum_{n=0}^{N-1}\exp\left[\frac{2\pi i}{\Phi_0}n\Phi\right]$ eine geometrische Reihe ist, mit dem Ergebnis $\left|S_N\right| = \frac{\sin(N\pi\,\Phi/\Phi_0)}{N\sin(\pi\,\Phi/\Phi_0)}$. Die Strukturfaktoren für solche dem derzeitigen Stand der Technik entsprechenden konventionellen SQUIDs besitzen somit unabhängig von der Zahl der Kontakte periodische Strukturfaktoren. Diese periodischen Strukturfaktoren sind die Ursache für die ebenfalls streng $\Phi_0$-periodischen Spannungsantwortfunktionen $\left\langle V(\vec{B};I_0) \right\rangle$ solcher Vorrichtungen, und

damit die Ursache dafür, dass mit solchen dem Stand der Technik entsprechenden Vorrichtungen eine absolute Messung des magnetischen Feldes nicht möglich ist. Supraleitende Quanten-Interferenz-Filter besitzen demgegenüber keine periodischen Strukturfaktoren, da $S_N(\vec{B})$ nach Gleichung 6 für inkommensurable akkumulierte magnetische Flüsse $\alpha_n$ keine Periodizität aufweisen kann. Supraleitende Quanten-Interferenz-Filter besitzen damit auch keine periodischen Spannungsantwortfunktionen $\langle V(\vec{B};I_0) \rangle$ und ermöglichen dadurch die absolute Messung magnetischer Felder.

Nach Gleichung 3 gilt für statische oder im Vergleich zur Netzwerkfrequenz langsam variierende äußere Felder $v_j(t)=v_1(t)$ für alle j = 1 ...N, d.h. $v_1(t)$ definiert die über den supraleitenden Quanten-Interfer.enz-Filter abfallende Wechselspannung. Die Netzwerkfrequenz $V$ hängt über die Einstein-Relation $h\nu = 2e\langle V(\vec{B};I_0) \rangle$ mit dem zeitlichen Mittelwert dieser Wechselspannung, der Spannungsantwortfunktion $\langle V(\vec{B};I_0) \rangle = \frac{1}{T}\int_0^T v_1(t)\,dt$ zusammen, wobei $T = \frac{1}{\nu}$ gilt. Für typische $Nb/AlO_x/Nb$-Josephsonkontakte liegt die Netzwerkfrequenz $V$ bei etwa 100 GHz, so dass die Frequenz $V_{ext}$ des äußeren Feldes in einem Bereich zwischen $V_{ext}=0$ bis etwa 20 GHz liegen kann. Als einfach zugängliche Messgröße kann wie bei konventionellen SQUIDs die im zeitlichen Mittel über das Netzwerk abfallende Gleichspannung $\langle V(\vec{B};I_0) \rangle$ dienen. Der Einfluss von Induktivitäten und durch den Treiberstrom verursachten Eigenfelder wird in Gleichung 4 und 5 der besseren Verständlichkeit halber vernachlässigt. Tatsächlich können Induktivitäten und Eigenfelder bei geeigneter Auslegung des supraleitenden Quanten-Interferenz-Filters so minimiert werden, dass deren Funktionsfähigkeit durch diese Einflüsse nicht beeinträchtigt wird. Entsprechende Vorrichtungen werden in den weiteren Ausführungsbeispielen vorgestellt.

Die Vernachlässigung der shunt-Kapazitäten $c_n$, die für typische Josephsonkontakte in sehr guter Näherung gerechtfertigt ist, ermöglicht eine analytische Lösung für die Spannungsantwortfunktion:

$$\langle V(B;I_0) \rangle = i_c\, r_n \sqrt{\left(\frac{I_0}{N\,i_c}\right)^2 - |S_N(B)|^2} \qquad (8)$$

Für alle dem derzeitigen Stand der Technik entsprechenden SQUIDs ist diese Spannungsantwortfunktion periodisch mit Periode $\Phi_0$, wie dies in Fig. 12a skizziert ist. Für SQIFs hingegen ist die Spannungsantwortfunktion nicht periodisch. Dies ist in Fig. 12c dargestellt. Die Spannungsantwortfunktion des supraleitenden Quanten-Interferenz-Filters besitzt wie die Spannungsantwortfunktion konventioneller SQUIDs ein Minimum für $\Phi=0$. Im Gegensatz zu konventionellen SQUIDs wiederholt sich dieses Minimum bei anwachsendem äußerem Feld jedoch nicht. Damit ist die Spannungsantwort für $\Phi=0$ eindeutig ausgezeichnet und ermöglicht je nach Auslegung direkt oder mit Hilfe einer geeigneten Kompensationsschaltung für das magnetische Feld die absolute quantitative Messung des äußeren magnetischen Feldes. Da der Betrag des Strukturfaktors $S_N$ in Gl. 8 quadratisch eingeht, schwankt die Spannungsantwortfunktion für die SQIFs auf dem oberen Teil des Graphen nur sehr leicht um den Wert $V_{max}$ und es ergibt sich eine ausgeprägt steile Flanke zwischen $V_{min}$ und $V_{max}$ (vgl. Fig. 12c).

Der Strukturfaktor $S_N(\vec{B})$ des supraleitenden Quanten-Interferenz-Filters kann derart optimiert werden, dass die Spannungsantwortfunktion $\langle V(\vec{B};I_0) \rangle$ einen maximalen Messbereich $0 < |\vec{B}| < |\vec{B}|_s$ besitzt. Dies ist dann der Fall, wenn der Abstand $\Delta V$ zwischen dem kleinsten lokalen Minimum von $V$ und dem maximalen Spannungswert $V_{max}$ für gegebene Gesamtfläche $\sum_{m=1}^{N-1}|\vec{a}_m|$ (vgl. auch Fig. 11) und gegebene Zahl der Netzwerkkontakte $N$ im Operationsbereich minimal wird. Der maximale Operationsbereich eines supraleitenden Netzwerkes ist dabei durch die maximal erreichbare Kompensationsfeldstärke bestimmt.

Für ebene Netzwerke kann der Fall eintreten, dass eine durch den Fertigungsprozess verursachte minimal mögliche Längenvariation $l_0$ der Leiterbahnen auftritt. Die Flächeninhalte $|\vec{a}_m|$ der Netzwerkschlaufen können dann durch $\left|\vec{a}_m\right| = q_m l_0^2$ definiert werden, wobei die Zahlen $q_m$ positive ganze Zahlen sind. Im ungünstigsten Fall dürfen sich damit zwei Flächenelemente fertigungsbedingt nur um den Betrag von $l_0^2$ unterscheiden. Dies führt dazu, dass der Strukturfaktor $S_N(\bar{B})$ und damit die Spannungsantwortfunktion $\left\langle V(\vec{B}; I_0) \right\rangle$ des supraleitenden Quanten-Interferenz-Filters rein theoretisch betrachtet periodisch variieren könnte. Die möglicherweise auftretende Periode ist allerdings in Bezug auf $\Phi_0$ sehr groß und entspricht $\frac{\Phi_0}{GGT} A_{tot}$ , wenn GGT der größte gemeinsame Teiler der Beträge $\left|\vec{a}_m\right|$ der orientierten Flächenelemente eines planaren Netzwerks ist und $A_{tot}$ die Gesamtfläche des SQIF, $A_{tot} = \Sigma_{m=1}^{N-1} \left|\vec{a}_m\right|$ bezeichnet. Ein typischer, dem Stand der Technik entsprechender Wert für $l_0$ beträgt etwa hundert *nm* (Niob-Prozess).

Die minimale Flächendifferenz $l_0^2$ liegt damit in der Größenordnung von $10^{-2} \mu m^2$ bei einer angenommenen Netzwerkzellenfläche des supraleitender Quanten-Interferenz-Filters von $10^{-2} mm^2$. Sind die Zahlen $q_m$ nun selbst teilerfremd, etwa dadurch, dass sie zu (verschiedenen) Primzahlen gewählt werden, dann ist die Periode der Spannungsantwortfunktion zu $\frac{\Phi_0}{l_0^2} A_{tot}$ gegeben. Diese Periode liegt für typische Gesamtflächen $A_{tot}$ von mehreren 1000 $\mu m^2$ weit außerhalb des praktisch relevanten Mess- oder Operationsbereichs. Für einen in einer bestimmten Anwendung gegebenen Operationsbereich existiert damit immer ein supraleitender Quanten-Interferenz-Filter mit optimaler Fläche, Kontaktanzahl und zugehörigem Strukturfaktor.

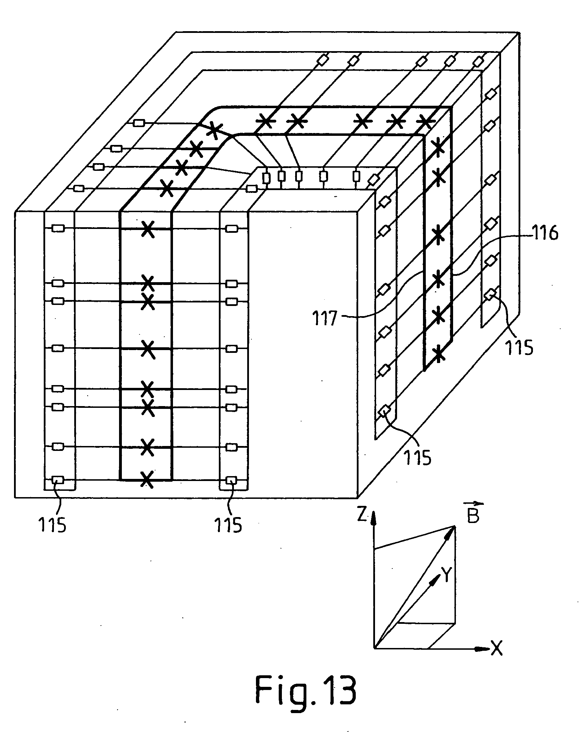

Ein weiteres Ausführungsbeispiel der Erfindung ist in Fig. 13 dargestellt. Die Netzwerkzellen zerfallen hier in drei Gruppen derart, dass aus den orientierten Flächenelementen $\vec{a}_m$ eine vollständige vektorielle Basis des dreidimensionalen Raumes gebildet werden kann. Diese Ausführung der Erfindung, die im Folgenden als Vektor-SQIF bezeichnet wird, hat den Vorteil, dass durch entsprechend ausgelegte Kompensationsfelder, die zum Beispiel jeweils ein kontrollierbares sekundäres Feld parallel zu jedem der aus den $\vec{a}_m$ gebildeten Basisvektoren erzeugen, sowohl die Stärke als auch die Richtung des zu messenden primären magnetischen Feldes eindeutig und mit sehr hoher Genauigkeit bestimmt werden kann. Dies ermöglicht die eindeutige quantitative Rekonstruktion des primären Magnetfeldvektors $\vec{B}_{ext}$ nach Betrag, Richtung und Phase, und erlaubt eine Vielzahl neuartiger Anwendungen. Schon mit zwei solcher Anordnungen ist es z.B. möglich, die Quellen eines magnetischen Feldes exakt zu lokalisieren und ihre Stärke zu bestimmen. Hierzu kann das drahtlose Auslesen von Detektorfeldern gehören, wenn die einzelnen Detektorsignale aus temporären elektrischen Strömen bestehen. Auch das Auslesen oder die Verarbeitung von elektronischen oder magnetischen Datenspeichern ist durch solche Anordnungen berührungslos und praktisch ohne Leistungsaufnahme oder -abgabe durch den SQIF bei einer sehr hohen zeitlichen Auflösung und damit einer extrem schnellen Verarbeitungsgeschwindigkeit im GHz bis THz Bereich möglich. Weitere Beispiele für die Anwendung solcher Vektor-SQIFs sind die räumlich und zeitlich hochaufgelöste Messung von Stoffwechselvorgängen, etwa im menschlichen Gehirn, von Signalen der Kernspin-Resonanz oder der Magnetfeldverteilung in der oberen Erdkruste, wie etwa in der Geoexploration. In Fig. 13 sind durch die Kreuze die Josephsonkontakte symbolisiert, mit dem Bezugszeichen 115 sind bus-bar-Widerstände bezeichnet. Die dicken durchgezogenen Linien stellen supraleitende Verbindungen dar. Die beiden dicken durchgezogenen Linien 116, 117 begrenzen zudem den supraleitend verbundenen Teil des Netzwerks.

In einem nicht dargestellten Ausführungsbeispiel ist der Vektor-SQIF aus drei unabhängig voneinander operierenden einzelnen ebenen SQIFs, deren Flächennormalen eine vektorielle Basis des dreidimensionalen Raumes bilden, aufgebaut. Diese Vorrichtung hat den Vorteil, dass die einzelnen ebenen SQIFs mit den dem derzeitigen Stand der Technik entsprechenden Standardmethoden der Dünnschichttechnologie problemlos gefertigt werden können. Die quantitative Messung kann hier entweder durch simultane Kompensation der drei Komponenten des äußeren Magnetfelds wie im Ausführungsbeispiel des letzten Abschnitts oder durch direkte Messung der an jedem einzelnen SQIF abfallenden Spannung erfolgen. Letztere Messmethode ist für bestimmte Anwendungen ein weiterer Vorteil solcher Anordnungen, da dann keine Kompensationsvorrichtungen notwendig sind.

In zwei weiteren nicht dargestellten Ausführungsbeispielen ist der Vektor-SQIF entsprechend dem letzten oder vorletzten Abschnitt so aufgebaut, dass die Flächennormalen der einzelnen SQIFs oder die orientierten Flächenelemente $\vec{a}_m$ derart angeordnet sind, dass aus ihnen eine vollständige vektorielle Basis eines zweidimensionalen Unterraumes des dreidimensionalen Raumes gebildet werden kann. Diese Ausführung kann dann von Vorteil sein, wenn das magnetische Feld nur in einer Ebene gemessen werden soll, z.B. wenn es sich um ebene Detektorfelder oder Speicher handelt.

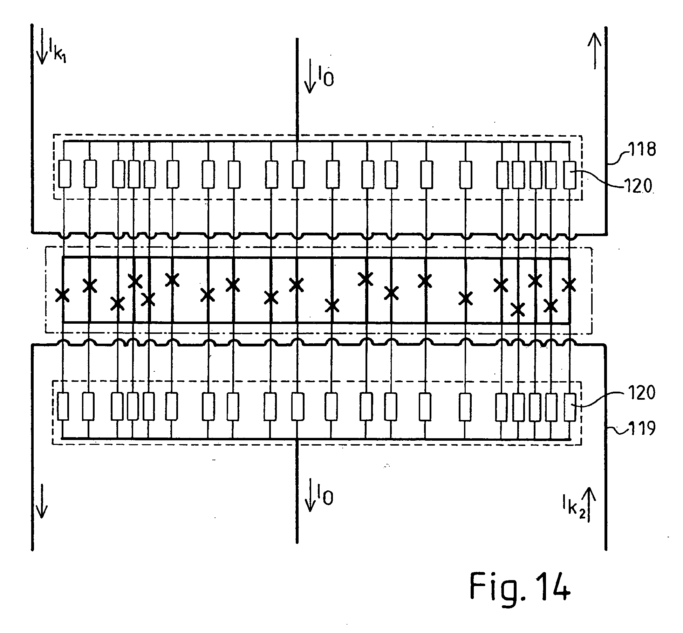

In Fig. 14 ist ein Ausführungsbeispiel eines ebenen SQIFs dargestellt, bei dem das magnetische Kompensationsfeld durch zwei Steuerleitungen 118, 119, welche parallel zum Netzwerk und damit senkrecht zur Richtung des treibenden Stromes liegen, erzeugt wird. Fließt in einer solchen erfindungsgemäßen Anordnung ein Strom Ik1, Ik2 durch eine oder beide Steuerleitungen 118, 119, so wird in die Zellen des SQIF ein durch diesen Strom sehr genau kontrollierbarer magnetischer Fluss bekannter Stärke eingekoppelt. Dieser Fluss kann den durch ein äußeres magnetisches Feld verursachten Fluss derart kompensieren, dass die über den SQIF abfallende Spannung minimal wird. Dieser sogenannte Arbeitspunkt liegt dann immer im absoluten Minimum der Eichkurve $\left\langle V(\vec{B}; I_0) \right\rangle$ des SQIF. Über den Wert des Kompensationsstroms kann, da der Abstand zwischen Steuerleitung und Netzwerk bekannt ist, die Stärke des äußeren Magnetfelds direkt bestimmt werden. Auch die Wahl eines anderen Arbeitspunkts innerhalb des Messbereichs des SQIF ist möglich. Diese Ausführung hat den Vorteil, dass der Operationsbereich des SQIF, d.h. der Bereich der Magnetfeldstärken, die mit der Vorrichtung gemessen werden können, prinzipiell nur durch Feldstärken, die die Phasenkohärenz zwischen den durch Tunnelbarrieren getrennten supraleitfähigen Bereichen zerstören, nach oben hin begrenzt ist. Ein weiterer Vorteil ist, dass in dieser Ausführung SQIFs auch dann noch voll funktionsfähig betrieben werden können, wenn der eigentliche Messbereich, d.h. der Bereich in dem die Spannungsantwortfunktion ein-eindeutig ist, sehr klein wird. Dies kann dann auftreten, wenn durch fertigungsbedingte Toleranzen Nebenminima der Spannungsantwortfunktion auftreten, deren Spannungswerte sich nicht sehr stark vom Spannungswert des absoluten Minimums unterscheiden. Solange der Messbereich jedoch größer als die Auflösungsgrenze des SQIF, die typischerweise bei einigen nV liegt, bleibt die Vorrichtung erfindungsgemäß in einer Ausführung mit Kompensationsschaltung voll funktionsfähig.

Vorteilhaft an einer Ausführung mit Steuerleitungen ist auch, dass die Kompensationsschaltung on-chip angebracht ist und keine zusätzlichen Fertigungsschritte erfordert. Entsprechend dem derzeitigen Stand der Technik können die Steuerleitungen bei Dünnschichtaufbauten in den über oder den unter den Netzwerk-Zuführungsleitungen liegenden Schichten angebracht werden. Auch das Anbringen von mehreren Steuerleitungen kann von Vorteil sein, etwa wenn zu Präzisionsmessungen einem statischen Kompensationsfeld ein zeitlich variierendes Kompensationsfeld überlagert werden soll.

Für Operationsmodi, bei denen zeitlich variierende Kompensationsfelder verwendet werden, sollten SQIFs ihre maximale Empfindlichkeit erreichen. In solchen Modi ist darüber hinaus nicht nur die simultane Bestimmung der Stärke und der Richtung des zu messenden Feldes, sondern auch seiner Phasenlage möglich. Dies erlaubt die vollständige Rekonstruktion des gemessenen zeitveränderlichen Signals und damit die Erstellung einer identischen Kopie dieses Signals. Der Vorteil der Vorrichtungen liegt darin, dass solche Kopien ohne jeden Informationsverlust verstärkt und weitergeleitet werden können.

In Fig. 14 symbolisieren wiederum die Kreuze die Josephsonkontakte. Mit dem Bezugszeichen 120 sind symbolisch dargestellte bus-bar-Widerstände bezeichnet. Die strichpunktierte Linie beschreibt die Begrenzung des notwendigerweise supraleitenden Teils des Netzwerks.

In einer nicht dargestellten Ausführung für Präzisionsmessungen ist die Kompensationsschaltung außerhalb des SQIF angebracht und besteht aus einem Spulenpaar, welches derart orientiert ist, dass der SQIF in einer Ebene senkrecht zur Achse des Spulenpaars zwischen den beiden Spulen liegt. Solche Kompensationsschaltungen können den Vorteil haben, dass das magnetische Kompensationsfeld am Ort des SQIF eine sehr hohe Homogenität aufweist und dadurch äußerst präzise Messungen ermöglicht. Auch Ausführungen, bei denen lokal, d.h. durch Steuerleitungen, und durch außerhalb des SQIF angebrachte Kompensationsschaltungen, kompensiert wird, können von Vorteil sein, um den Einfluss von Störungen, wie etwa Rauschen und Fluktuationen, zu minimieren. SQIF, welche über Kompensationsschaltungen, etwa in Form von Steuerleitungen verfügen, können auch als Logikbauelemente (Aktoren) für ultraschnelle Hochleistungsrechner verwendet werden. SQIFs mit zwei lokalen Steuerleitungen können ODER-Logikbausteine bereitstellen, die nur dann schalten, wenn durch beide Steuerleitungen ein exakt gleicher paralleler Strom fließt. Die Schaltzeiten solcher Aktoren liegen dabei im Bereich der Netzwerkfrequenz, d.h. im GHz bis THz Bereich. Ein Vorteil solcher Logikbausteine liegt dabei auch darin, dass sie gleichzeitig als Verstärker wirken, da sehr kleine Steuerströme bereits zur maximalen Spannungsantwort führen, die für heutzutage typische Josephsonkontakte mehrere hundert $\mu$V bis $mV$ beträgt.

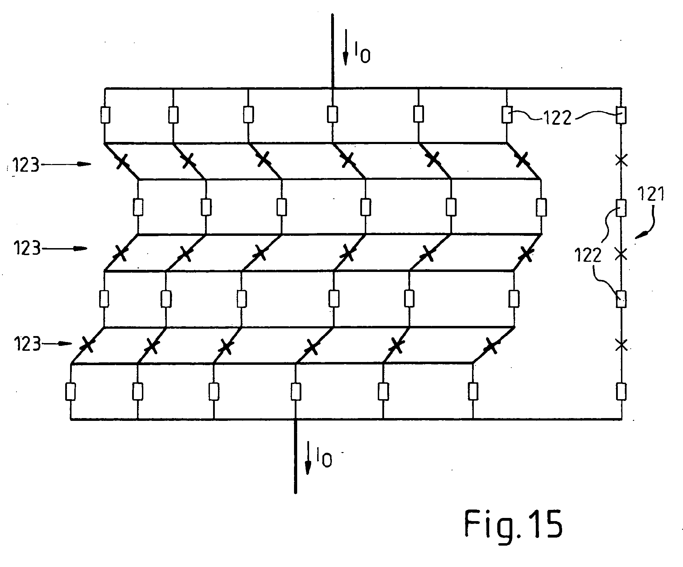

Durch eine Serienschaltung von SQIFs, wie dies in Fig. 15 dargestellt ist, die durch eine aktive Steuerleitung 121, welche ihrerseits wiederum Josephsonkontakte enthält, miteinander gekoppelt sind, kann die Empfindlichkeit bzw. der Verstärkungsfaktor der erfindungsgemäßen Anordnungen vervielfacht werden. Die Kreuze symbolisieren Josephsonkontakte. Mit dem Bezugszeichen 122 sind symbolisch dargestellte bus-bar-Widerstände bezeichnet. Die dick ausgezogenen Linien innerhalb des Netzwerks repräsentieren supraleitende Verbindungen und symbolisieren den supraleitenden Bereich 123, der auch die Josephsonkontakte enthält.

Die aktive Steuerleitung 121 bewirkt hierbei eine Synchronisation des eindimensionalen SQIF-arrays auch bei stark abweichenden Strukturfaktoren der verschiedenen SQIF-Abschnitte und Parameterinhomogenitäten. Sind die Fertigungstoleranzen klein, kann unter Umständen auf die aktive Steuerleitung auch verzichtet werden. Der Vorteil solcher SQIF-arrays, die auch zweidimensional ausgelegt sein können, liegt darin, dass die Auflösungsgrenze der Vorrichtung mit der Zahl der SQIF-Abschnitte 123 abnimmt und der Verstärkungsfaktor mit der Zahl der SQIF-Abschnitte anwächst. Im Bereich der Magnetfeldmessung sollten sich mit solchen Anordnungen bei optimaler Wahl des Operationsmodus zum Beispiel Auflösungsgrenzen erreichen lassen, die viele Größenordnungen niedriger sind als die bei konventionellen SQUID-Systemen. Auch SQIF-arrays lassen sich mit den dem Stand der Technik entsprechenden Fertigungsverfahren problemlos herstellen.

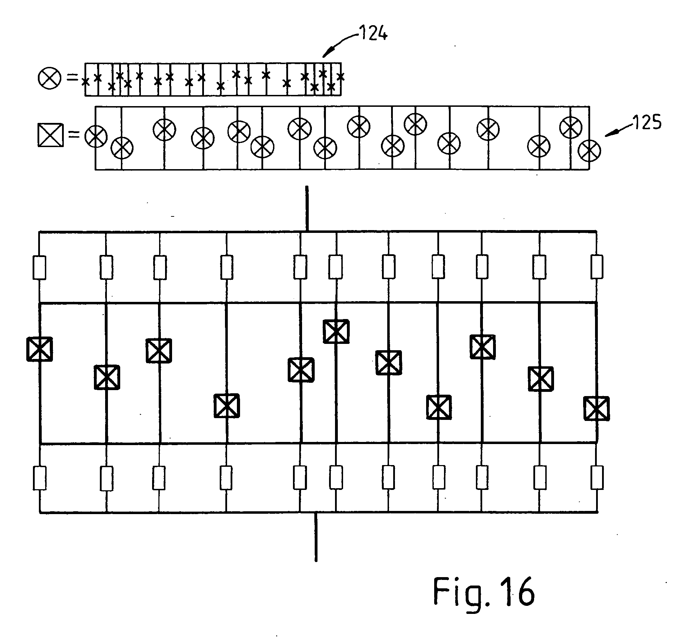

Ein Ausführungsbeispiel bei dem mehrere SQIF-Abschnitte 124 in einem hierarchisch gegliederten SQIF-array verschaltet sind, ist in Fig. 16 gezeigt. Die Basiselemente eines solchen hierarchischen SQIF-arrays sind hier identische Basis-SQIFs 124 mit identischem Strukturfaktor. Diese Basis-SQIFs sind auf einer zweiten Hierarchieebene wiederum in Form eines SQIFs 125 angeordnet, welcher erneut als Basis-SQIF 125 für eine dritte Hierarchieebene dient. Auch Anordnungen mit mehr als drei Hierarchieebenen ($k$=1,2,3,...) sind möglich. Der Vorteil solcher Anordnungen liegt darin, dass je nach den Verhältnissen der orientierten Flächenelemente des Basis-SQIF und dem oder der SQIFs höherer Hierarchieebenen, bedingt durch die im Allgemeinen verschiedenen Strukturfaktoren auf den verschiedenen Ebenen, die Interferenzmuster, die auf den verschiedenen Ebenen erzeugt werden, wiederum zu einem Gesamtmuster interferieren, was eine außerordentlich hohe Auflösung ermöglicht. Da die orientierten Flächenelemente $\vec{a}_m$ in den verschiedenen Hierarchieebenen unterschiedlich ausgerichtet werden können, ist das resultierende Interferenzmuster zudem extrem sensitiv bezüglich der Richtung des äußeren Feldes. Nach dem derzeitigen Stand der Fertigungstechnik können solche mehrdimensional ausgelegten SQIF-Systeme nicht on-chip realisiert werden. Es ist jedoch möglich, die einzelnen ebenen Bestandteile eines mehrdimensionalen SQIF-Systems mit herkömmlichen Methoden der Dünnschichttechnologie herzustellen und diese dann mit supraleitenden twisted-pair-Kabeln so zu verbinden, dass ein Gesamtsystem der beschriebenen Art entsteht. Solche supraleitenden twisted-pair-Kabel haben dabei den Vorteil, dass in sie kein effektiver Fluss eindringt. Die Verbindung verschiedener Teile eines SQIF-Systems mit solchen supraleitenden twisted-pair-Kabeln beeinflusst die Funktionsfähigkeit des Gesamt-SQIFs daher nicht, da in G1. 6 das Kabel lediglich als orientiertes Flächenelement mit verschwindend kleiner Fläche eingeht.

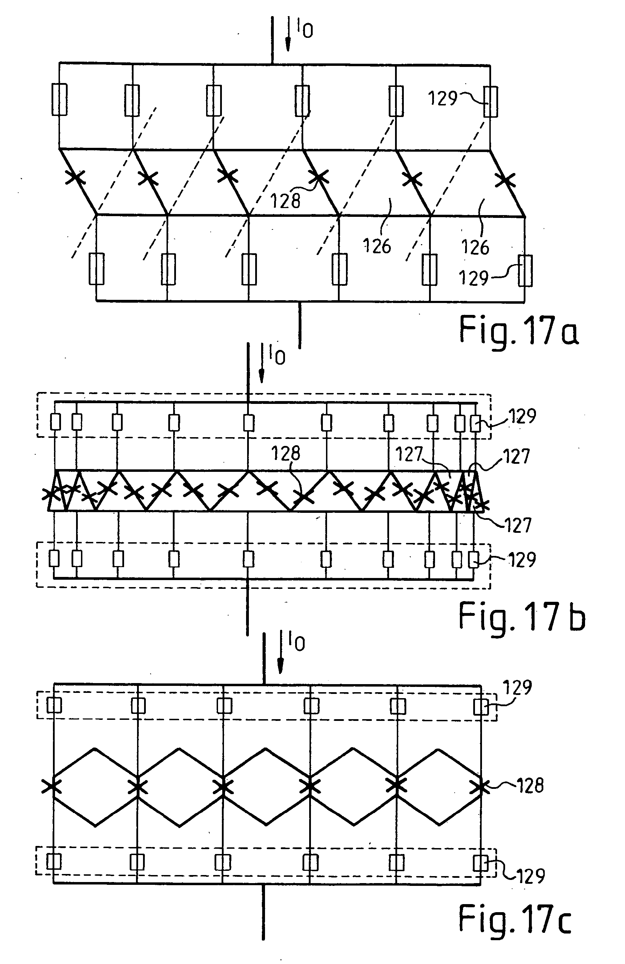

Ein Ausführungsbeispiel eines SQIF, das zeigt, wie die zwischen den verschiedenen Netzwerkzellen wirksamen induktiven Kopplungen minimiert werden können, ist in Fig. 17a dargestellt. Solche induktiven Kopplungen können die Empfindlichkeit der Vorrichtung vermindern, wenn das Netzwerk aus sehr vielen Zellen besteht. Da durch jeden Kontakt ein überkritischer Strom fließt, erzeugt die resultierende Stromverteilung in diesem Fall ein Eigenfeld, das unter Umständen nicht vernachlässigt werden kann. Durch erfindungsgemäße Ausführungen, wie sie etwa in Fig. 17b dargestellt sind, lässt sich der Einfluss der Eigenfelder stark reduzieren. In Fig. 17a und 17b sind die Leiterbahnen der Netzwerkzellen 126, 127 so ausgeführt, dass der durch einen Netzwerkkontakt 128 fließende Strom in der jeweils übernächsten Netzwerkzelle nur einen vernachlässigbaren Fluss induziert, da das magnetische Feld eines stromdurchflossenen kurzen Leiterstücks im Wesentlichen auf einen Bereich senkrecht zum Leiterstück beschränkt ist. Da für Φ=0 jeder Kontakt von einem Strom gleicher Stärke durchflossen wird, verschwinden für diesen Fall alle Induktivitäten und das globale Minimum der Spannungsantwortfunktion entspricht dem nach Gl. 8. Um die Eigenfelder der stromzuführenden und abführenden Leitungen zu minimieren, wird der Treiberstrom $I_0$ durch dem Stand der Technik entsprechende bus-bar-Widerstände 129, deren Entfernung zum Netzwerk groß genug gewählt werden kann, zu- und wieder abgeführt. Eine alternative, die gegenseitigen induktiven Einflüsse ebenfalls minimierende Ausführung eines SQIF ist in Fig. 17c dargestellt.

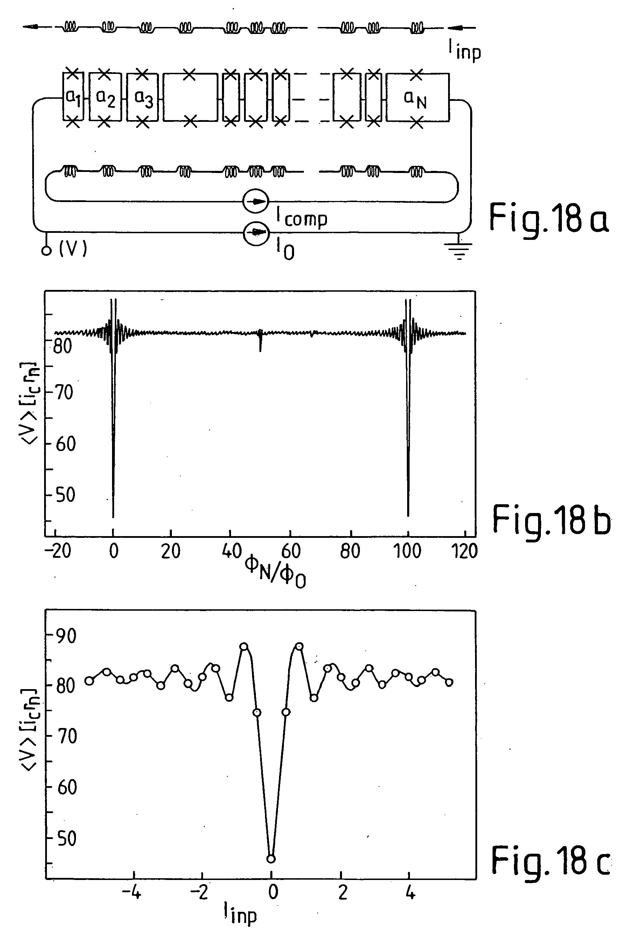

Ein Ausführungsbeispiel, bei dem die verschiedenen Netzwerkzellen in Serie geschaltet sind, ist in Fig. 18a dargestellt. Die orientierten Flächenelemente $\vec{a}_m$ sind auch hier so gewählt, dass die Spannungsantwortfunktion des Netzwerks nicht periodisch ist oder nur eine im Vergleich zu $\Phi_0$ sehr große Periode besitzt. Im Fall einer nichtperiodischen Spannungsantwortfunktion liegt genau bei $\vec{B}=0$ das globale absolute Minimum dieser Spannungsantwortfunktion. In Fig. 18b ist eine typische Spannungsantwortfunktion einer Serienschaltung für $N$=100 Netzwerkzellen a1 bis a100 und sehr großer Periode dargestellt.

Solche Ausführungen besitzen den Vorteil, dass sich bedingt durch die Serienschaltung die Spannungsantwortfunktionen der einzelnen Netzwerkzellen addieren. Dadurch entsteht ein Quanten-Interferenz-Filter mit einem sehr großen Spannungshub, der bis in den Bereich mehrerer mV oder gar V kommen kann. Im Gegensatz zur Parallelschaltung ergibt sich dabei jedoch keine Verminderung der Breite der Spannungsantwortfunktion (Varianz) um $\vec{B}=0$ im Vergleich zu konventionellen zwei-Kontakt-SQUIDs. Da der Abstand benachbarter Netzwerkschlaufen in Serienanordnungen jedoch beliebig gewählt werden kann, ohne die Quanteninterferenzbedingung zu verletzen, können mit solchen Anordnungen die parasitären gegenseitigen Induktivitäten minimiert werden. Zudem können Serienschaltungen bei der Fertigung technisch bedingte Vorteile haben. Insbesondere ist eine erhöhte Packungsdichte möglich, was bei der Integration der Schaltungen auf einem Chip von Vorteil sein kann.

Die theoretische Beschreibung von Serien-SQIFs kann mit Hilfe von Gleichung 8 erfolgen, da ein Serien-SQIF die einfachste Realisierung eines zweidimensionalen SQIF-arrays darstellt. Für identische Netzwerkkontakte ist die über einer einzelnen Netzwerkzelle für einen überkritischen Treiberstrom $I_0 > 2i_c$ abfallende mittlere Gleichspannung durch

$$\langle V \rangle_n = i_c \, r_n \, \sqrt{\left(\frac{I_0}{2\,i_c}\right)^2 - \left|\cos(\pi\frac{\Phi_n}{\Phi_0})\right|^2} \qquad (9)$$

gegeben, wobei $\Phi_n = \langle \vec{B}, \vec{a}_n \rangle$ gilt. Die über das gesamte Serienarray abfallende mittlere Gleichspannung $\langle V \rangle$ ergibt sich daraus zu

$$\langle V \rangle = \sum_{n=1}^{N} \langle V \rangle_n \qquad (10)$$

Zwar kann, bedingt durch die Serienanordnung der Netzwerkzellen $\vec{a}_n$, nicht direkt ein Strukturfaktor wie für die Parallelanordnung definiert werden, durch entsprechende Wahl der Folge $\{\vec{a}_n\}$ ist es jedoch auch hier möglich, den Verlauf der Spannungsantwortfunktion und insbesondere den Mess- bzw. Operationsbereich einzustellen.

Im Ausführungsbeispiel der Fig. 18b etwa wurden die orientierten Flächenelemente $\vec{a}_n$ in einer ebenen Serienanordnung entsprechend der arithmetischen Relation

$$a_n = \frac{n}{N} a_N \qquad (11)$$

gewählt, wobei $a_n = |\vec{a}_n|$ gilt und $a_N$ die größte Fläche des Serien-SQIF mit $N$ Netzwerkzellen und $2N$ Kontakten bezeichnet. Eine solche Wahl hat z.B. den Vorteil, dass das Maximum der Spannungsantwortfunktion direkt auf das Minimum folgt (vgl. Fig. 18b) und so der Spannungshub maximal wird.

In Fig. 18a ist neben dem Serien-SQIF eine typische Ankoppel- und Steuerschaltung schematisch eingezeichnet. Bei entsprechender Auslegung wird durch den Kompensationsstrom $I_{comp}$ am Ort der einzelnen Netzwerkzellen ein magnetisches Kompensationsfeld erzeugt, das ein äußeres Feld und/oder das Feld, das durch den Strom $I_{inp}$ erzeugt wird, kompensiert. Dies ermöglicht den Betrieb des SQIF im extrem empfindlichen Nullabgleichmodus. Der Strom $I_{inp}$ ist dabei etwa der input-Strom einer pick-up-loop- oder einer anderen Signalquelle.

Serien-SQIFs können auch deshalb von großem Vorteil sein, weil das Eigenrauschen der Schaltung, etwa bei ihrer Verwendung als (Strom-) Verstärker, nur proportional zu $\sqrt{N}$ anwächst, während der Spannungshub proportional zu $N$ anwächst. Dies ist deshalb der Fall, weil das Spannungsrauschen der unterschiedlichen Netzwerkzellen, bzw. der Josephsonkontakte in diesen Zellen, nicht korreliert ist (reine Stromkopplung), und sich daher nur inkohärent überlagern. Mit Serien-SQIFs oder allgemeinen SQIF-Arrays lassen sich dadurch etwa extrem rauscharme Verstärker realisieren. Eine typische Strom-Spannungskennlinie eines solchen Verstärkerbauteils, das durch einen SQIF realisiert werden kann, ist in Fig. 18c dargestellt. Je nach Auslegung des SQIF können in diesem Operationsmodus auch sehr kleine Ströme ($<10^{-12}A$) detektiert bzw. verstärkt werden. Weitere Vorteile solcher Verstärkerbauteile sind ihre sehr schnellen Schaltzeiten und ihre Anwendbarkeit bis zu sehr hohen Frequenzen.

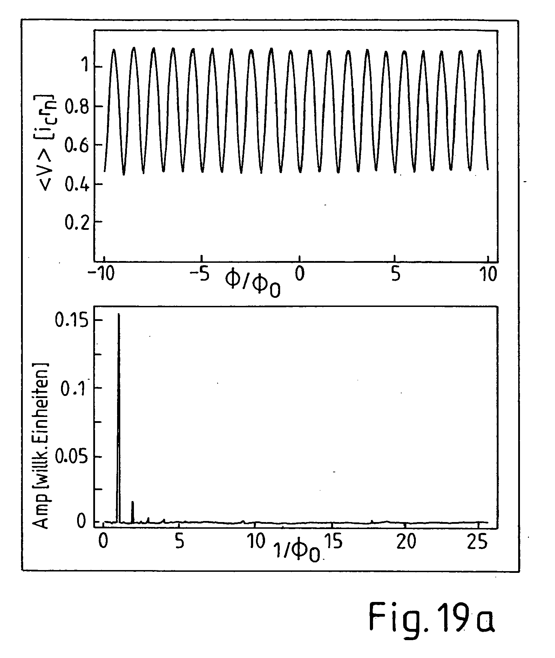

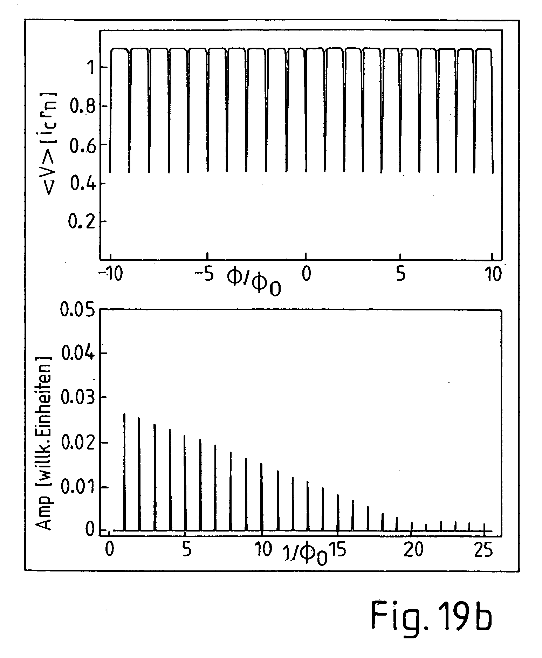

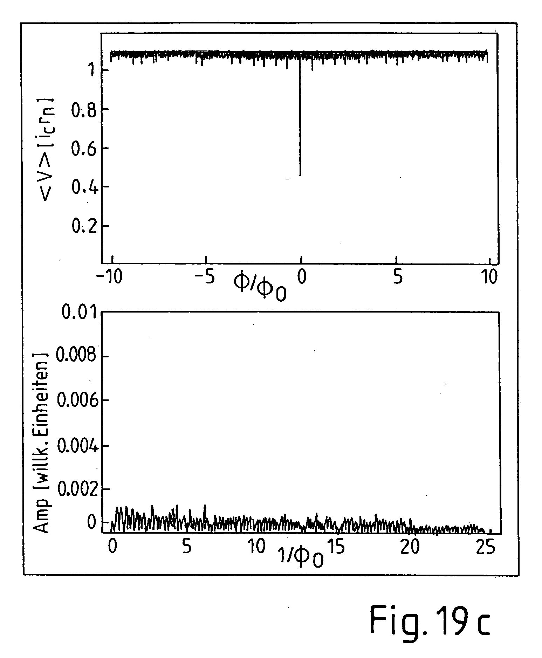

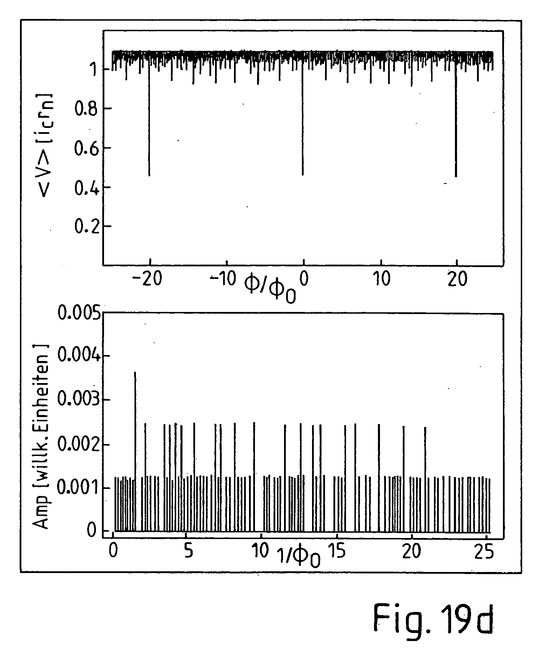

Die Periodizitätseigenschaften der Spannungsantwortfunktion sind ein wesentliches Merkmal von SQIFs. Das Frequenzspektrum der Spannungsantwortfunktionen von SQIFs in Bezug auf den magnetischen Fluss unterscheidet sich daher eindeutig von konventionellen SQUID-Interferometern. Dieser Sachverhalt ist in den Fig. 19a bis 19d anhand von typischen Frequenzspektren von SQUIDs (Fig. 19a und 19b) und von SQIFs (Fig. 19c und 19d) dargestellt.

Fig. 19a zeigt im oberen Bild die typische Spannungsantwortfunktion eines herkömmlichen SQUID. Die $\langle V(\Phi)\rangle$-Kurve ist periodisch mit der Periode $\Phi_0$. Das zugehörige Frequenzspektrum im unteren Bild der Fig. 19a zeigt dementsprechend eine bei weitem dominierende Amplitude bei $1/\Phi_0$. Da die Spannungsantwortfunktion eines SQUID nicht harmonisch ist (vgl. Gl.8), treten zusätzlich noch höhere harmonische Moden bei $2\Phi_0$ und $3\Phi_0$ auf, die jedoch lediglich eine sehr kleine Amplitude besitzen. Das Frequenzspektrum herkömmlicher SQUIDs wird damit vom $\Phi_0$-periodischen Beitrag dominiert. Wie Fig. 19b zeigt, ist dies auch bei Mehrschlaufenanordnungen, welche aus identischen Netzwerkzellen aufgebaut sind, der Fall, und zwar unabhängig davon, ob es sich um Serienanordnungen oder Parallelanordnungen identischer SQUID-Schlaufen handelt. Auch bei Parameterimperfektionen oder geometrischen Imperfektionen zeigen dem Stand der Technik entsprechende Quanten-Interferometer immer ein diskretes Frequenzspektrum, das vom $\Phi_0$-periodischen Beitrag dominiert wird. Bei Imperfektionen zusätzlich auftreten kann lediglich ein zusätzliches kontinuierliches Spektrum, das von den Imperfektionen herrührt und von der Art der Imperfektionen abhängt.

Quanten-Interferenz-Filter hingegen besitzen keinen dominanten $\Phi_0$-periodischen Beitrag im Frequenzspektrum ihrer Spannungsantwortfunktionen. Dieser Sachverhalt ist in Fig. 19c und Fig. 19d dargestellt. Die Frequenzspektren in den Fig. 19a bis 19c (untere Bilder) sind in den jeweils gleichen willkürlichen Einheiten aufgetragen, so dass ein direkter Vergleich möglich ist. Die Spannungsantwort und das zugehörige Frequenzspektrum eines Quanten-Interferenz-Filters, welche keine Periodizität besitzt, ist in Fig. 19c gezeigt. Das Spektrum ist praktisch kontinuierlich, ein diskretes Spektrum existiert nicht. Insbesondere existiert kein signifikanter $\Phi_0$ periodischer Beitrag. Die Amplituden des praktisch kontinuierlichen Spektrums sind um zwei bzw. eine Größenordnung kleiner als bei den herkömmlichen Anordnungen nach Fig. 19a bzw. Fig. 19b. In Fig. 19d ist die Spannungsantwortfunktion und das zugehörige Spektrum eines Quanten-Interferenz-Filters dargestellt, welcher eine technisch bedingte Periodizität besitzt. Die Spannungsantwortfunktion hat die Eigenschaft, dass ihre Periode sehr viel größer als $\Phi_0$ ist und das Frequenzspektrum besitzt einen diskreten Anteil mit einer sehr kleinen Amplitude bei der Periode $\Phi_0$. Diese Amplitude bei der Periode $\Phi_0$ ist nicht signifikant und liefert jedenfalls keinen dominanten Beitrag zum Frequenzspektrum. Das diskrete Spektrum ist zudem wiederum dadurch ausgezeichnet, dass dessen Amplituden im Vergleich zu den herkömmlichen Anordnungen um ein bis zwei Größenordnungen kleiner sind.

Die Frequenzspektren der Quanten-Interferenz-Filter sind im Hinblick auf den $\Phi_0$-periodischen Beitrag des Frequenzspektrums robust. Parameterimperfektionen oder geometrische Imperfektionen verändern die oben beschriebenen qualitativen Eigenschaften der Anordnungen nicht.

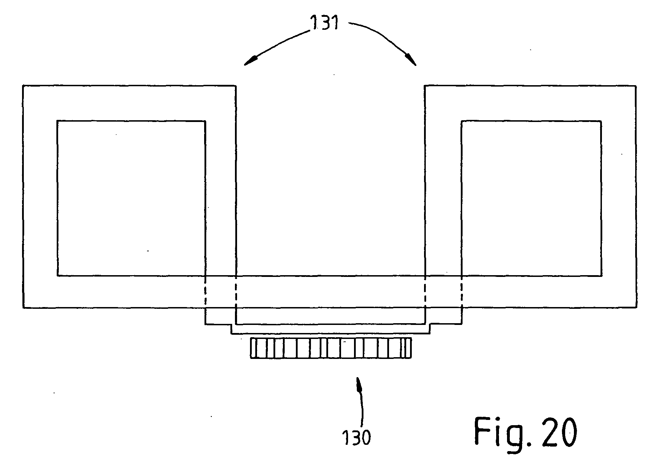

In Fig. 20 ist ein Ausführungsbeispiel eines ebenen SQIF 130 schematisch dargestellt, das mit einer supraleitenden Einkoppelschlaufe (pick-up-loop) versehen ist. Solche Einkoppelschlaufen verstärken das primäre magnetische Feld, indem sie den durch dieses Feld in ihrem Innern erzeugten Fluss nach außen verdrängen. Solche Vorrichtungen haben den Vorteil, dass durch eine geeignete Anordnung das primäre magnetische Feld am Ort des SQIF stark verstärkt werden kann. Ein weiterer Vorteil von SQIFs besteht darin, dass die Gesamtfläche von SQIFs so ausgelegt werden kann, dass die Impedanz-Fehlanpassung zwischen pick-up-loop und SQIF minimiert wird. Die Empfindlichkeit und die Auflösung von SQIFs kann durch solche Vorrichtungen erheblich gesteigert werden. Anstatt eines pick-up-loop können auch supraleitende Flächen (sog. washer) verwendet werden, welche ebenfalls zu den genannten Vorteilen führen. Auch die Ankopplung einer Gradiometerschlaufe ist möglich und führt zu den genannten Vorteilen bei der Messung von Magnetfeldgradienten. Bei der Detektion zeitveränderlicher elektromagnetischer Felder sind geeignet ausgelegt supraleitende Einkoppelschlaufen ebenfalls von Vorteil, da sie gleichzeitig als Empfangsantennen dienen können.

**Patentansprüche**

1. Magnetometer mit geschlossenen supraleitenden eine Stromschleife bildende Zellen (23, 24, 26), die jeweils mehrere, vorzugsweise zwei, Josephsonkontakte (28, 29) enthalten wobei die Zellen (23, 24, 25, 26) einen supraleitenden Quanten-Interferenz-Filter (1, 9, 27) bilden, bei welchem wenigstens drei dieser Zellen supraleitend und/oder nicht supraleitend in Verbindung stehen, die Kontakte der wenigstens drei Zellen derart bestrombar sind, dass jeweils über mindestens zwei Kontakte einer Zelle eine zeitveränderliche Spannung abfällt, deren zeitliches Mittel nicht verschwindet, die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass die Spannungsantwortfunktion in Bezug auf den magnetischen Fluss keine Periodizität mit der Periode $\Phi_0$ besitzt, so dass das Frequenzspektrum der Spannungsantwortfunktion in Bezug auf den magnetischen Fluss keinen signifikanten $\Phi_0$-periodischen Anteil besitzt, oder dass, falls ein diskretes Frequenzspektrum existiert, der Beitrag des $\Phi_0$-periodischen Anteils des diskreten Frequenzspektrums im Vergleich zu den nicht $\Phi_0$-periodischen Anteilen des diskreten Frequenzspektrums nicht dominant ist, **dadurch gekennzeichnet, dass** eine Elektronikeinheit vorgesehen ist, und dass der supraleitende Quanten-Interferenz-Filter (27) selbst geometrisch derart ausgebildet ist, dass eine Messung der räumlichen Ableitung von magnetischen Feldern erster oder höherer Ordnung möglich ist.

2. Magnetometer nach einem der vorhergehenden Ansprüche, **dadurch gekennzeichnet, dass** das Magnetometer (8) mehrere SQIFs (9) enthält, welche einzeln oder in Gruppen von einer einzelnen oder mehreren Elektronikeinheiten (5) und durch eine einzelne oder mehrere Rückkoppelschlaufen (4) getrennt oder gemeinsam steuerbar sind.

Fig. 8

Fig. 9a

Fig. 9b

EP 1 717 593 A2

Fig.10a

Fig.10d

Fig.10b

Fig.10e

Fig.10c

Fig.10f

Fig.10

Fig.11

Fig.12 a

Fig.12 b

Fig.12 c

Fig. 12 d

Fig.13

Fig. 14

Fig.15

Fig. 16

Fig. 17a

Fig. 17 b

Fig. 17c

Fig. 18 a

Fig. 18 b

Fig. 18 c

Fig. 19 a

Fig. 19 b

Fig. 19 c

Fig. 19d

Fig. 20

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10043657 A1

**In der Beschreibung aufgeführte Nicht-Patentliteratur**

- **HANSEN, BINSLEV J. ; LINDELOF P.E.** Static and dynamic interactions between Josephson junctions. *Reviews of Modern Physics,* 03. Juli 1984, vol. 56, 431-459